# EUROPEAN PATENT SPECIFICATION

(11) **EP 3 693 404 B1**
(45) Date of publication and mention of the grant of the patent: **07.06.2023**
(21) Application number: 19870061.9
(22) Date of filing: 22.11.2019
(51) Int. Cl.: C08G 61/10, C08G 61/12, H01L 51/50, H01L 51/00

(54) **POLYMER COMPOUND, METHOD FOR PRODUCING POLYMER COMPOUND, AND LIGHT-EMITTING ELEMENT**
POLYMERVERBINDUNG, HERSTELLUNGSVERFAHREN FÜR POLYMERVERBINDUNG UND LICHTEMITTIERENDE VORRICHTUNG
COMPOSÉ POLYMÈRE, PROCÉDÉ DE PRODUCTION D'UN COMPOSÉ POLYMÈRE, ET ÉLÉMENT ÉLECTROLUMINESCENT

(30) Priority: 12.12.2018 JP 2018232245
(43) Date of publication of application: 12.08.2020
(73) Proprietor: Sumitomo Chemical Company, Limited, Tokyo 104-8260 (JP)
(72) Inventor: TERAI, Hiroki, Osaka-shi Osaka 554-8558 (JP)
(74) Representative: J A Kemp LLP
(86) International application number: PCT/JP2019/045791
(87) International publication number: WO 2020/121783

(56) References cited:
- WO-A1-2013/058160
- WO-A1-2017/047644
- JP-A- 2010 010 246
- JP-A- 2014 209 531
- JP-A- 2016 138 275
- JP-A- 2016 536 412
- US-B1- 6 605 693

## Description

### Technical Field

The present invention relates to a polymer compound, a production method of a polymer compound, and a light emitting device.

### Background Art

In order to produce an organic layer of an organic electroluminescence element by a coating method such as an ink jet printing method, research and development of a polymer compound soluble in a solvent as a material for forming the organic layer has been conducted. In order to efficiently prepare an ink for coating, a polymer compound having high dissolution rate in a solvent is required.

For example, Non-Patent Document 1 describes a copolymer composed of 9,9'-dioctylfluorene-2,7-diboronic acid propanediol ester and 4,4'-dibromotriphenylamine, as such a polymer compound. Patent Documents 1 and 2 relates to conjugated polymers containing triptycene units and their use as electroluminescent materials.

Patent document 3 describes a compound containing a structure represented by the formula below, the use of this compound in a coating method using a highly polar solvent, and the use of this compound in producing an electroluminescent element.

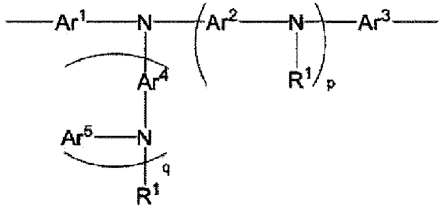

Patent document 4 describes an organic photoelectric conversion element having a pair of electrodes in which at least one electrode is transparent or translucent, and an optical active layer and a function layer between the electrodes. The optical active layer comprises an electron supplying compound and an electron receptive compound. The function layer comprises a cross-linked polymer compound in which a high molecular compound having a structure represented by the following formula is cross-linked.

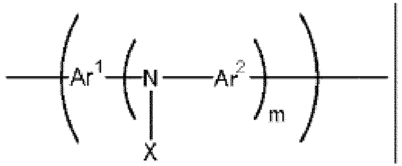

Patent document 5 describes a thermoelectric conversion material containing a nono conductive material and a low band gap material, and its use in a thermoelectric conversion layer in a thermoelectric conversion element.

Patent document 6 describes a monopolymer containing an asymmetric substituted repeating unit having a substituent binding to a carbon atom at 9 position of a fluorene ring via a non-aromatic carbon atom and having a substituent of a benzene ring structure having H or a substituent on a carbon atom at another 9 position, which is a linear alkyl which may have a substituent at other than 9 position on the fluorene ring, where the substituent at 9 position on the fluorene ring is substituted by one or more group - (Ar)w, where each Ar represents independently an aryl or heteroaryl group which may be substituted.

Patent document 7 describes a method for producing a bioabsorbable polyester in powder form having a bulk density of 0.3 g/ml or more, a tap density of 0.4 g/ml or more, and a specific surface area of 2.0 m/g or less, comprising: dissolving a bioabsorbable polyester in a first solvent; contacting the resulting polymer solution with a non-solvent for the bioabsorbable polyester that is primarily water; pre-drying the resulting wet polymer mass; grinding the pre-dried polymer mass into polymer particles having a size below 10 mm; drying the polymer particles to a residual moisture content of no more than 1% w/w; heating the polymer particles; and grinding the polymer particles from to a powder having a particular particle size.

### [Prior Art Document]

### [Non-Patent Document]

[Non-Patent Document 1] RSC Adv., 2017, 7, 54431-54440
[Patent Document 1] US 6 605 693 B1
[Patent Document 2] WO 2017/047644 A1
[Patent Document 3] WO 2013/058160 A1
[Patent Document 4] JP 2010 010246 A
[Patent Document 5] JP 2014 209531 A
[Patent Document 6] JP 2016 138275 A
[Patent Document 7] JP 2016 536412 A

### Summary of the Invention

### Problem to be Solved by the Invention

However, the above-mentioned polymer compound did not always have sufficient dissolution rate in a solvent.

Accordingly, an object of the present invention is to provide a polymer compound having high dissolution rate in a solvent, a method for producing the polymer compound, and a light emitting device using the polymer compound as a material.

### Means for Solving the Problem

The present invention provides the following [1] to [10] .
[1] A polymer compound consisting of:
   (i) at least one constitutional unit selected from the group consisting of a constitutional unit represented by the following formula (1-1) and a constitutional unit represented by the following formula (1-2),
      wherein the constitutional unit represented by the formula (1-1) may be contained only singly or in combination of two or more kinds thereof, and the constitutional unit represented by the formula (1-2) may be contained only singly or in combination of two or more kinds thereof;
      and, optionally,
   (ii) at least one other constitutional unit that is a divalent organic group obtained by directly bonding only one or more divalent aromatic hydrocarbon groups, only one or two divalent hetero ring groups, or at least one divalent aromatic hydrocarbon group and at least one divalent hetero ring group, and the divalent groups obtained by directly bonding the two or more divalent aromatic hydrocarbon groups, the two or more divalent hetero ring groups, or the at least one divalent aromatic hydrocarbon group and the at least one divalent hetero ring group may be bonded directly to form a divalent organic group or may be bonded via at least one group selected from the group consisting of an alkylene group, a group represented by -O-, a group represented by -S- and a group represented by -(CO)-, to form a divalent organic group,
      wherein said other constitutional unit may be contained only singly or in combination of two or more kinds thereof;
      wherein the tap density is 0.02 g/cm³ or more and 0.13 g/cm³ or less: 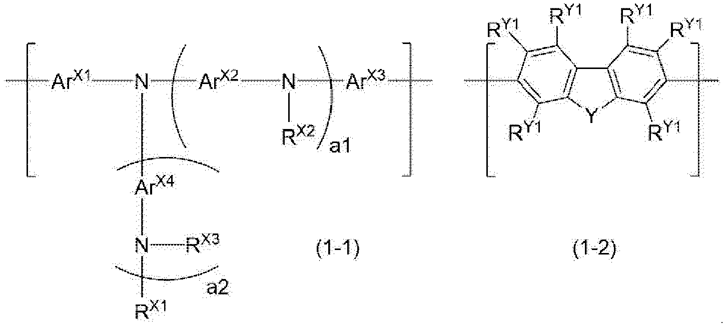 in the formula (1-1),
      a1 and a2 each independently represent an integer of 0 or more and 2 or less,
      Ar^{X1} represents a direct bond, a divalent aromatic hydrocarbon group, a divalent hetero ring group, or a divalent group in which at least one divalent aromatic hydrocarbon group and at least one divalent hetero ring group are bonded directly, and the foregoing groups optionally have a substituent,
      Ar^{X2}, Ar^{X3} and Ar^{X4} each independently represent a divalent aromatic hydrocarbon group, a divalent hetero ring group, or a divalent group in which at least one divalent aromatic hydrocarbon group and at least one divalent hetero ring group are bonded directly, and the foregoing groups optionally have a substituent, and when a plurality of Ar^{X2} and Ar^{X4} are present, they may be the same or different at each occurrence,
      R^{X1}, R^{X2} and R^{X3} each independently represent an alkyl group, an aryl group or a monovalent hetero ring group, and the foregoing groups optionally have a substituent, and when a plurality of R^{X2} and R^{X3} are present, they may be the same or different at each occurrence,
      in the formula (1-2),
      R^{Y1} represents a hydrogen atom, an alkyl group, an aryl group or a monovalent hetero ring group, and the foregoing groups optionally have a substituent, a plurality of R^{Y1} may be the same or different,
      Y represents a group represented by -C(R^{Y2})₂-, - C(R^{Y2})=C(R^{Y2})-, -C(R^{Y2})₂-C(R^{Y2})₂-, -C(R^{Y2})₂-C(R^{Y2})₂-C(R^{Y2})₂-, -N(R^{Y2})- or -O-,
      R^{Y2} represents a hydrogen atom, an alkyl group, an alkoxy group, an aryl group or a monovalent hetero ring group, and the foregoing groups optionally have a substituent, and when a plurality of R^{Y2} are present, they may be the same or different, and the plurality of R^{Y2} may be combined together to form a ring together with carbon atoms to which they are attached, and when the plurality of R^{Y2} form a ring, the group represented by -C(R^{Y2})₂- is a group represented by the formula (Y-1) to the formula (Y-5), and the foregoing groups optionally have a substituent: 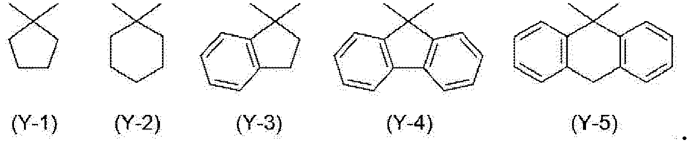
[2] The polymer compound according to [1], wherein the glass transition temperature is 80°C or higher and 200°C or lower.
[3] The polymer compound according to [1] or [2], wherein the content of the constitutional unit represented by the formula (1-1) and the constitutional unit represented by the formula (1-2) is 1 to 100% by mol with respect to the total amount of constitutional units contained in the polymer compound.
[4] The polymer compound according to any one of [1] to [3], wherein the amount of the constitutional unit represented by the formula (1-1) is 5% by mol or more and 90% by mol or less with respect to the total amount of constitutional units contained in the polymer compound.
[5] The polymer compound according to any one of [1] to [4], wherein the amount of the constitutional unit represented by the formula (1-2) is 5% by mol or more and 90% by mol or less with respect to the total amount of constitutional units contained in the polymer compound.
[6] The polymer compound according to any one of [1] to [5], wherein the polymer compound has a polystyrene-equivalent weight-average molecular weight, Mw, in a range of 1×10³ to 1×10⁸.
[7] A method of producing a polymer compound as defined in any one of [1] to [6], the method comprising a step of mixing a mixture containing:
   (A) a polymer compound consisting of: (i) and (ii) as defined in [1] and
   (B) a good solvent for said polymer compound;

   with a poor solvent for said polymer compound at a temperature of 35°C or higher and 75°C or lower and removing the resultant precipitate,
   wherein
   the good solvent is a solvent in which said polymer compound can be dissolved without decomposing the polymer compound, and a solvent in which the solubility of said polymer compound is 1g polymer compound / 100g good solvent or more at 20°C, and
   the poor solvent is a solvent in which said polymer compound is difficult to dissolve without decomposing the polymer compound, and a solvent in which the solubility of said polymer compound is less than 1g polymer compound / 100g poor solvent at 20°C.
[8] The production method according to [7], wherein said good solvent is an aromatic hydrocarbon.
[9] The production method according to [7] or [8], wherein the amount of said poor solvent is 300 parts by weight or more with respect to 100 parts by weight of said good solvent.
[10] A light emitting device comprising an anode, a cathode, and an organic layer formed by using the polymer compound according to any one of [1] to [6] disposed between said anode and said cathode.

### Effect of the Invention

According to the present invention, it is possible to provide a polymer compound having high dissolution rate in a solvent and a method of producing the polymer compound.

### Modes for Carrying Out the Invention

Hereinafter, preferred embodiments of the present invention will be described.

### <Explanation of common terms>

Terms commonly used in the present specification have the following meanings unless otherwise stated.

"Hydrogen atom" may be a light hydrogen atom or a heavy hydrogen atom.

"Alkyl group" denotes a linear, branched or cyclic alkyl group. The linear alkyl group has a number of carbon atoms of usually 1 to 50, preferably 3 to 30, more preferably 4 to 20. The branched and cyclic alkyl groups have a number of carbon atoms of usually 3 to 50, preferably 3 to 30, more preferably 4 to 20. The alkyl group includes, for example, a methyl group, an ethyl group, a n-propyl group, an isopropyl group, a n-butyl group, an isobutyl group, a tert-butyl group, a n-pentyl group, an isoamyl group, a 2-ethylbutyl group, a n-hexyl group, a cyclohexyl group, a n-heptyl group, a cyclohexylmethyl group, a cyclohexylethyl group, a n-octyl group, a 2-ethylhexyl group, a 3-n-propylheptyl group, a n-decyl group, a 3,7-dimethyloctyl group, a 2-ethyloctyl group, a 2-n-hexyldecyl group, a n-dodecyl group and the like.

"Alkyl group" optionally has a substituent, and the substituent includes, for example, a fluorene atom, a cyano group, an aryl group, a monovalent hetero ring group, an alkoxy group, an aryloxy group, a substituted amino group, a carboxyl group, an esterified carboxyl group, an alkenyl group, an alkynyl group, a metal complex-containing group and the like. "Alkyl group" optionally has 1 to 20 substituents selected from these substituents. The substituted alkyl group includes, for example, a trifluoromethyl group, a pentafluoroethyl group, a perfluorobutyl group, a perfluorohexyl group, a perfluorooctyl group, a 3-phenylpropyl group, a 3-(4-methylphenyl)propyl group, a 3-(3,5-di-n-hexylphenyl)propyl group, a 6-ethyloxyhexyl group and the like.

"Aryl group" denote a monovalent group obtained by removing from an aromatic hydrocarbon one hydrogen atom bonding correctly to a carbon atom constituting the ring. The aromatic hydrocarbon has a number of carbon atoms of usually 6 to 60, preferably 6 to 20, more preferably 6 to 10. The aryl group includes, for example, a phenyl group, a 1-naphthyl group, a 2-naphthyl group, a 1-anthracenyl group, a 2-anthracenyl group, a 9-anthracenyl group, a1-pyrenyl group, a 2-pyrenyl group, a 4-pyrenyl group, a 2-fluorenyl group, a 3-fluorenyl group, a 4-fluorenyl group and the like.

"Aryl group" optionally has a substituent, and the substituent includes, for example, a halogen atom (particularly a fluorene atom), a cyano group, an alkyl group, an aryl group (the aryl group optionally has 1 to 3 substituents selected from the group consisting of an alkyl group and an alkoxy group), a monovalent hetero ring group, an alkoxy group, an aryloxy group, a substituted amino group, an alkylene group (a dimethylene group, a trimethylene group or the like) and the like. "Aryl group" optionally has 1 to 10 substituents selected from these substituents. The substituted aryl group includes, for example, a pentafluorophenyl group, a 4-hexylphenyl group, a 4-phenylphenyl group, a benzocyclobutenyl group and the like.

"Alkoxy group" denotes a linear, branched or cyclic alkoxy group. The linear alkoxy group has a number of carbon atoms of usually 1 to 40, preferably 4 to 10. The branched and cyclic alkoxy groups have a number of carbon atoms of usually 3 to 40, preferably 4 to 10. The alkoxy group includes, for example, a methoxy group, an ethoxy group, a n-propyloxyl group, an isopropyloxy group, a n-butyloxy group, an isobutyloxy group, a tert-butyloxy group, a n-pentyloxy group, a n-hexyloxy group, a cyclohexyloxyl group, a n-heptyloxy group, a n-octyloxy group, a 2-ethylhexyloxy group, a n-nonyloxy group, a n-decyloxy group, a 3,7-dimethyloctyloxy group, a lauryloxy group and the like.

"Alkoxy group" optionally has a substituent, and the substituent includes, for example, a fluorene atom, a cyano group, an aryl group, a monovalent hetero ring group, an alkoxy group, an aryloxy group, a substituted amino group, a carboxyl group, an esterified carboxyl group, an alkenyl group, an alkynyl group, a metal complex-containing group and the like. "Alkoxy group" optionally has 1 to 10 substituents selected from these substituents.

"Aryloxy group" denotes a monovalent group obtained by substituting one hydrogen atom bonding directly to a carbon atom constituting the ring of an aromatic hydrocarbon with an oxygen atom. The aryloxy group has a number of carbon atoms of usually 6 to 60, preferably 7 to 48. The aryloxy group includes, for example, a phenoxyl group, a 1-naphthyloxy group, a 2-naphthyloxy group, a 1-anthracenyloxy group, a 9-anthracenyloxy group, a 1-pyrenyloxy group and the like.

"Aryloxy group" optionally has a substituent, and the substituent includes, for example, a fluorene atom, a cyano group, an alkyl group, a monovalent hetero ring group, an alkoxy group, an aryloxy group, a substituted amino group, a carboxyl group, an esterified carboxyl group, an alkenyl group, an alkynyl group, a metal complex-containing group and the like. "Aryloxy group" optionally has 1 to 10 substituents selected from these substituents. The substituted aryloxy group includes, for example, a pentafluorophenoxy group, a 4-hexylphenoxy group, a 4-phenylphenoxy group and the like.

"Substituted amino group" denotes an amino group having two substituents. The substituent includes, for example, an alkyl group, an aryl group (the aryl group optionally has an alkyl group), a monovalent hetero ring group and the like. The substituted amino group includes, for example, a dialkylamino group, a diarylamino group and a di(mono or dialkylaryl)amino group, specifically, for example, a dimethylamino group, a diethylamino group, a diphenylamino group, a bis(4-methylphenyl)amino group, a bis(4-tert-butylphenyl)amino group, a bis(3,5-di-tert-butylphenyl)amino group and the like.

"Esterified carboxyl group" denotes a group represented by the formula: -COOR' (R' represents an alkyl group, an aryl group, a monovalent hetero ring group or the like.). The esterified carboxyl group includes, for example, an alkyloxycarbonyl group and an aryloxycarbonyl group, specifically, for example, a group represented by -CO₂CH₃, a group represented by -CO₂C₂H₅, a group represented by - CO₂C₆H₅ and the like.

"Alkenyl group" may be any of linear, branched or cyclic. The linear alkenyl group has a number of carbon atoms of usually 2 to 30, preferably 2 to 20. The branched and cyclic alkenyl group have a number of carbon atoms of usually 3 to 30, preferably 4 to 20. The alkenyl group includes, for example, a vinyl group, a 1-propenyl group, a 2-propenyl group, a 2-buten-1-yl group, a 3-buten-1-yl group, a 1-cyclohexenyl group, a 1-norbornyl group, a 2-norbornyl group and the like.

"Alkenyl group" optionally has a substituent, and the substituent includes, for example, a fluorene atom, a cyano group, an aryl group, a monovalent hetero ring group, an alkoxy group, an aryloxy group, a substituted amino group, a carboxyl group, an esterified carboxyl group, a metal complex-containing group and the like. "Alkenyl group" optionally has 1 to 20 substituents selected from these substituents. The substituted alkenyl group includes, for example, a 2-phenylethenyl group, a 4-octyl-2-phenylethenyl group and the like.

"Alkynyl group" may be any of linear, branched or cyclic. The linear alkynyl group has a number of carbon atoms of usually 2 to 30, preferably 2 to 20. The branched and cyclic alkynyl group have a number of carbon atoms of usually 4 to 30, preferably 4 to 20. The alkynyl group includes, for example, an ethynyl group, a 1-propynyl group, a 2-propynyl group, a 2-butyn-1-yl group, a 3-butyn-1-yl group and the like.

"Alkynyl group" optionally has a substituent, and the substituent includes, for example, a fluorene atom, a cyano group, an aryl group, a monovalent hetero ring group, an alkoxy group, an aryloxy group, a substituted amino group, a carboxyl group, an esterified carboxyl group, a metal complex-containing group and the like. "Alkynyl group" optionally has 1 to 20 substituents selected from these substituents. The substituted alkynyl group includes, for example, a 2-phenylethynyl group, a 4-octyl-2-phenylethynyl group and the like.

"Metal complex-containing group" denotes a group containing a complex formed of a metal atom and a ligand coordinating the metal atom. For example, groups represented by any of the formula (C-1) to the formula (C-4) are listed. 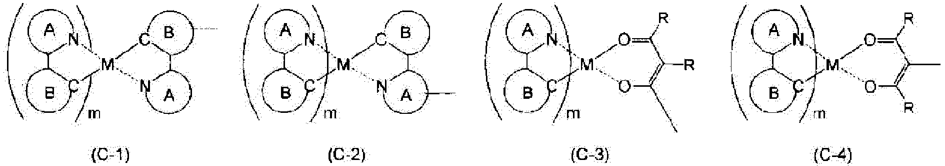 [wherein, M is Ir or Pt. m = 2 when M is Ir, while m = 1 when M is Pt. Ring A represents a nitrogen atom-containing cyclic structure optionally having a substituent. Ring B represents a carbon atom-containing cyclic structure optionally having a substituent. R represents a hydrogen atom, a fluorene atom, a cyano group, an alkyl group, an aryl group, a monovalent hetero ring group, an alkoxy group, an aryloxy group, a substituted amino group, a carboxyl group, an esterified carboxyl group, an alkenyl group, an alkynyl group or a metal complex-containing group. R optionally has a substituent, when it is a substitutable group. When a plurality of R are present, they may be the same or different. Adjacent groups R may be combined together to form a ring together with carbon atoms to which they are attached.]

Ring A includes, for example, nitrogen-containing aromatic rings (pyridine and the like). Ring B includes, for example, aromatic rings (benzene and the like) or hetero aromatic rings (dibenzothiophene and the like). Ring A and Ring B optionally have a substituent. Each of Ring A and Ring B optionally has, for example, 1 to 4 substituents selected from a fluorene atom, a cyano group, an alkyl group, an aryl group, a monovalent hetero ring group, an alkoxy group, an aryloxy group, a substituted amino group, a carboxyl group, an esterified carboxyl group, an alkenyl group, an alkynyl group and the like.

"Divalent aromatic hydrocarbon group" denotes a divalent group obtained by removing from an aromatic hydrocarbon two hydrogen atoms bonding directly to carbon atoms constituting the ring, and a divalent group obtained by bonding several (for example, 2 to 5) groups selected from the group consisting of the divalent groups. The divalent aromatic hydrocarbon group has a number of carbon atoms of usually 6 to 60, preferably 6 to 30, more preferably 6 to 18. The divalent aromatic hydrocarbon group includes, for example, a phenylene group, a naphthalenediyl group, an anthracenediyl group, a phenanthrenediyl group, a dihydrophenanthrenediyl group, a naphthacenediyl group, a fluorenediyl group, a pyrenediyl group, a perylenediyl group, a chrysenediyl group and the like.

"Divalent aromatic hydrocarbon group" optionally has a substituent, and the substituent includes, for example, a fluorene atom, a cyano group, an alkyl group, an aryl group (the aryl group optionally has 1 to 5 substituents selected from the group consisting of an alkyl group, an alkoxy group, a phenyl group and an alkylphenyl group), a monovalent hetero ring group, an alkoxy group, an aryloxy group, a substituted amino group, a carboxyl group, an esterified carboxyl group, an alkenyl group, an alkynyl group, a metal complex-containing group and the like. "Divalent aromatic hydrocarbon group" optionally has 1 to 10 substituents selected from these substituents. The divalent aromatic hydrocarbon group optionally having the substituent includes, for example, groups represented by the formula (A-1) to the formula (A-20). 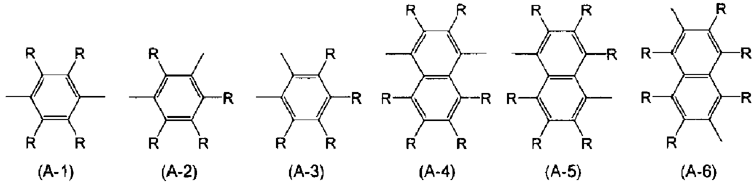 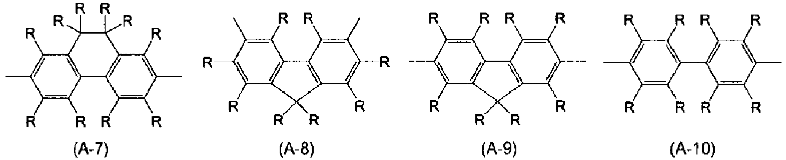 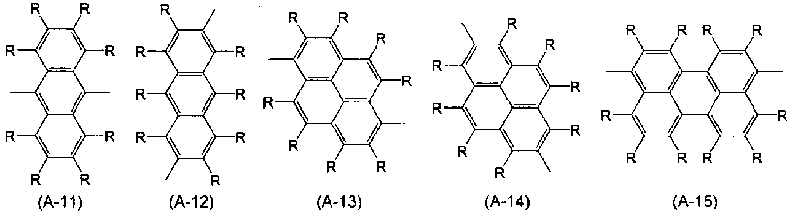 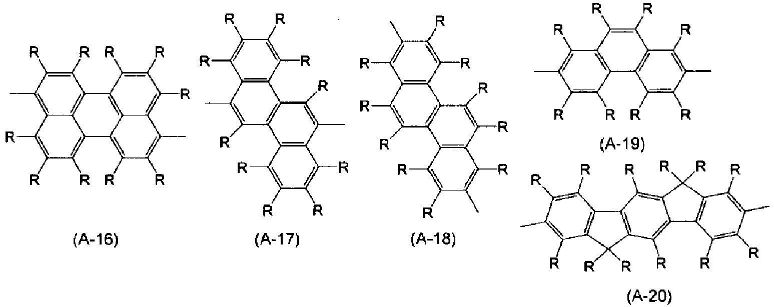 [wherein, R represents the same meaning as described above.]

"Monovalent hetero ring group" denotes a monovalent group obtained by removing from a heterocyclic compound one hydrogen atom among hydrogen atoms bonding directly to carbon atoms or hetero atoms constituting the ring. Of monovalent hetero ring groups, preferable is "monovalent aromatic hetero ring group" which is a monovalent group obtained by removing from an aromatic heterocyclic compound one hydrogen atom among hydrogen atoms bonding directly to carbon atoms or hetero atoms constituting the ring. "Monovalent hetero ring group" includes, for example, a thienyl group, a pyrrolyl group, a furyl group, a pyridyl group, a piperidyl group, a quinolyl group, an isoquinolyl group, a pyrimidinyl group, a triazinyl group and the like.

"Aromatic heterocyclic compound " denotes, for example, any of a compound in which the hetero ring itself shows aromaticity such as oxadiazole, thiadiazole, thiazole, oxazole, thiophene, pyrrole, phosphole, furan, pyridine, pyrazine, pyrimidine, triazine, pyridazine, quinoline, isoquinoline, carbazole, dibenzosilole, dibenzophosphole and the like; a compound in which an aromatic ring is condensed to a hetero ring even if the hetero ring itself shows no aromaticity such as phenoxazine, phenothiazine, dibenzoborole, dibenzosilole, benzopyran and the like; and a compound obtained by bonding a plurality of these compounds.

"Monovalent hetero ring group" optionally has a substituent, and the substituent includes, for example, a halogen atom (particularly a fluorene atom), a cyano group, an alkyl group, an aryl group, a monovalent hetero ring group, an alkoxy group, an aryloxy group, a substituted amino group, an alkylene group and the like. The monovalent hetero ring group optionally has 1 to 5 substituents selected from these substituents.

"Divalent hetero ring group" denote a divalent group obtained by removing from a heterocyclic compound two hydrogen atoms among hydrogen atoms bonding directly to carbon atoms or hetero atoms constituting the ring. Of divalent hetero ring groups, preferable is "divalent aromatic hetero ring group" which is a divalent group obtained by removing from an aromatic heterocyclic compound two hydrogen atoms among hydrogen atoms bonding directly to carbon atoms or hetero atoms constituting the ring. "Divalent hetero ring group" includes, for example, divalent groups obtained by removing from an aromatic heterocyclic compound two hydrogen atoms among hydrogen atoms bonding directly to carbon atoms or hetero atoms constituting the ring, such as pyridine, diazabenzene, triazine, azanaphthalene, diazanaphthalene, carbazole, dibenzofuran, dibenzothiophene, dibenzosilole, phenoxazine, phenothiazine, acridine, dihydroacridine, furan, thiophene, azole, diazole, triazole, oxazole, oxadiazole, thiazole, thiadiazole and the like, and divalent groups obtained by bonding several (for example, 2 to 4) groups selected from the group consisting of these divalent groups.

"Divalent hetero ring group" optionally has a substituent, and the substituent includes, for example, a fluorene atom, a cyano group, an alkyl group, an aryl group, a monovalent hetero ring group, an alkoxy group, an aryloxy group, a substituted amino group, a carboxyl group, an esterified carboxyl group, an alkenyl group, an alkynyl group, a metal complex-containing group and the like. The divalent hetero ring group optionally has 1 to 5 substituents selected from these substituents. The divalent hetero ring group optionally having the substituent is preferably a group represented by the formula (A-21) to the formula (A-45). 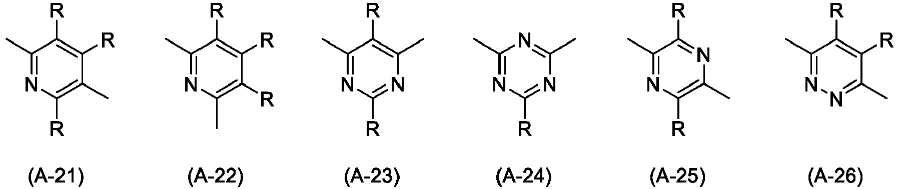 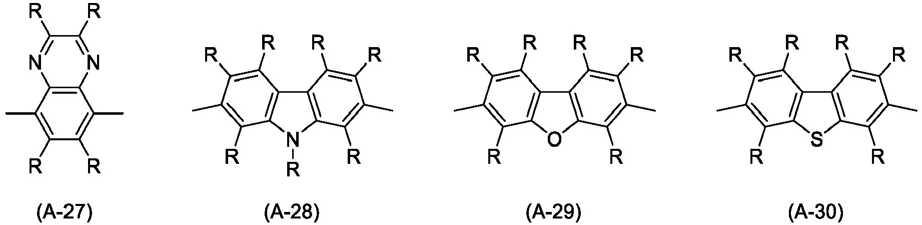 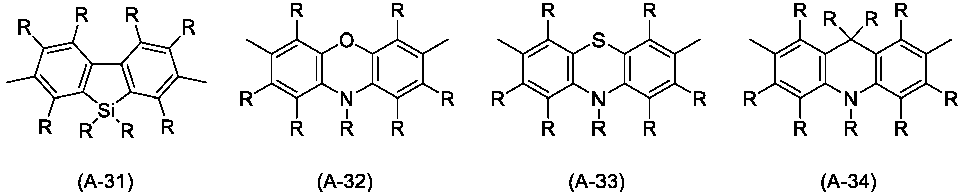 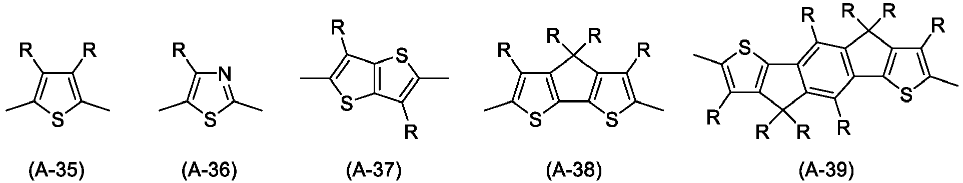 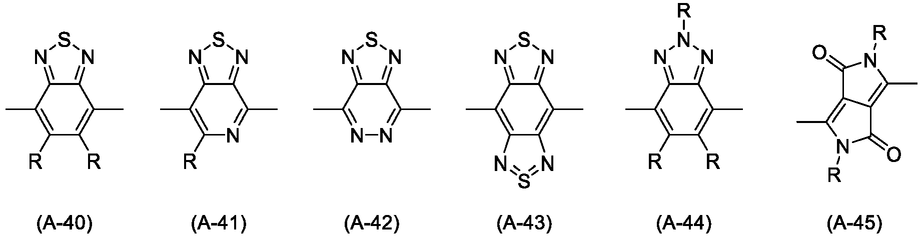 [wherein, R represents the same meaning as described above.]

"Divalent group in which at least one divalent aromatic hydrocarbon group and at least one divalent hetero ring group are bonded" means a divalent group in which one or two or more of the above-described divalent aromatic hydrocarbon groups and one or two or more of the above-described divalent hetero ring groups are arbitrarily bonded. The divalent aromatic hydrocarbon group and the divalent hetero ring group include those described above.

"Divalent group in which at least one divalent aromatic hydrocarbon group and at least one divalent hetero ring group are bonded" optionally has a substituent, and on the divalent aromatic hydrocarbon group as its partial structure, 1 to 10 substituents selected from a fluorene atom, a cyano group, an alkyl group, an aryl group, a monovalent hetero ring group, an alkoxy group, an aryloxy group, a substituted amino group, a carboxyl group, an esterified carboxyl group, an alkenyl group, an alkynyl group and a metal complex-containing group described above may be present, and on the divalent hetero ring group as the other partial structure, 1 to 5 substituents selected from a fluorene atom, a cyano group, an alkyl group, an aryl group, a monovalent hetero ring group, an alkoxy group, an aryloxy group, a substituted amino group, a carboxyl group, an esterified carboxyl group, an alkenyl group, an alkynyl group and a metal complex-containing group described above may be present.

"Constitutional unit" means a unit occurring once or more times in the polymer compound.

### <Polymer compound>

The polymer compound of the present invention is a polymer compound containing at least one constitutional unit selected from the group consisting of a constitutional unit represented by the formula (1-1) and a constitutional unit represented by the formula (1-2), wherein the tap density is 0.02 g/cm³ or more and 0.13 g/cm³ or less:

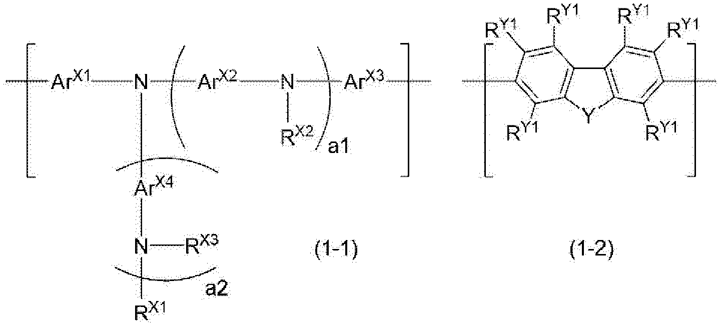

In the formula (1-1):
a1 and a2 each independently represent an integer of 0 or more and 2 or less.
Ar^{X1} represents a direct bond, a divalent aromatic hydrocarbon group, a divalent hetero ring group, or a divalent group in which at least one divalent aromatic hydrocarbon group and at least one divalent hetero ring group are bonded directly, and the foregoing groups optionally have a substituent.
Ar^{X2}, Ar^{X3} and Ar^{X4} each independently represent a divalent aromatic hydrocarbon group, a divalent hetero ring group, or a divalent group in which at least one divalent aromatic hydrocarbon group and at least one divalent hetero ring group are bonded directly, and the foregoing groups optionally have a substituent. When a plurality of Ar^{X2} and Ar^{X4} are present, they may be the same or different at each occurrence.
R^{X1}, R^{X2} and R^{X3} each independently represent an alkyl group, an aryl group or a monovalent hetero ring group, and the foregoing groups optionally have a substituent. When a plurality of R^{X2} and R^{X3} are present, they may be the same or different at each occurrence.

In the formula (1-2):
R^{Y1} represents a hydrogen atom, an alkyl group, an aryl group or a monovalent hetero ring group, and the foregoing groups optionally have a substituent. A plurality of R^{Y1} may be the same or different.
Y represents a group represented by -C(R^{Y2})₂-, - C(R^{Y2})=C(R^{Y2})-, -C(R^{Y2})₂-C(R^{Y2})₂-, -C(R^{Y2})₂-C(R^{Y2})₂-C(R^{Y2})₂, -N(R^{Y2})- or -O-.
R^{Y2} represents a hydrogen atom, an alkyl group, an alkoxy group, an aryl group or a monovalent hetero ring group, and the foregoing groups optionally have a substituent. When a plurality of R^{Y2} are present, they may be the same or different, and the plurality of R^{Y2} may be combined together to form a ring together with carbon atoms to which they are attached. When the plurality of R^{Y2} form a ring, the group represented by -C(R^{Y2})₂- is a group represented by the formula (Y-1) to the formula (Y-5), and the foregoing groups optionally have a substituent:

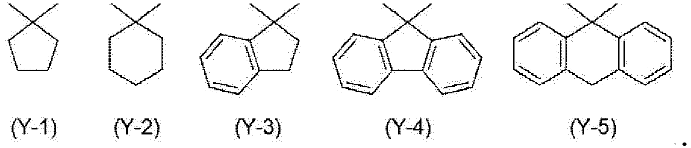

The tap density is preferably 0.03 g/cm³ or more, more preferably 0.04 g/cm³ or more, further preferably 0.05 g/cm³ or more, since the dissolution rate of the polymer compound of the present invention in a solvent is increased. Further, it is preferably 0.12 g/cm³ or less, more preferably 0.11 g/cm³ or less, further preferably 0.10 g/cm³ or less. A polymer compound having a tap density within the above range has a high dissolution rate in a solvent.

The upper limit value and the low limit value described above may be combined arbitrarily.

### [Constitutional unit represented by the formula (1-1)]

a1 is preferably 0 or 1.
a2 is preferably 0.
Ar^{X1} is preferably a direct bond, a divalent aromatic hydrocarbon group or a divalent hetero ring group, more preferably a divalent aromatic hydrocarbon group.
Ar^{X2}, Ar^{X3} and Ar^{X4} are each preferably a divalent aromatic hydrocarbon group or a divalent hetero ring group, more preferably a divalent aromatic hydrocarbon group.
R^{X1}, R^{X2} and R^{X3} are each preferably an alkyl group or an aryl group, more preferably an aryl group.

The constitutional unit represented by the formula (1-1) includes, for example, constitutional units represented by the formula (X-1) to the formula (X-9), and is preferably a constitutional unit represented by the formula (X-1) to the formula (X-7), more preferably a constitutional unit represented by the formula (X-3) to the formula (X-7). 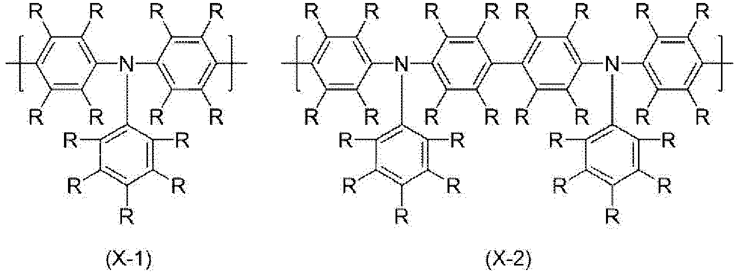 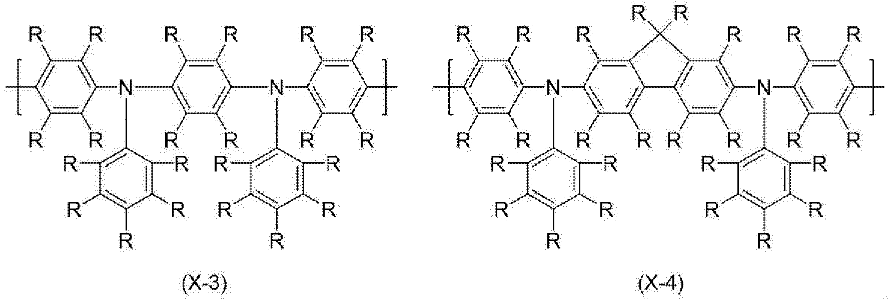 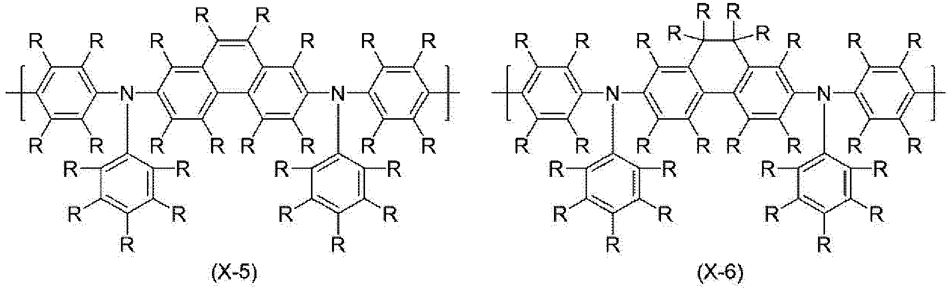 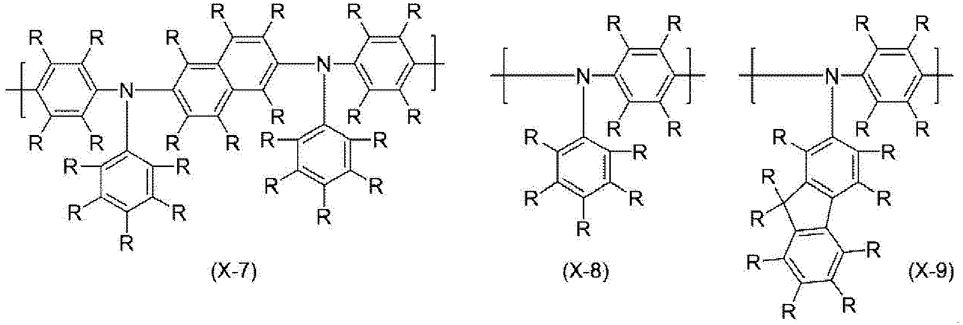 [wherein, R represents the same meaning as described above.]

In the polymer compound of the present invention, the amount of the constitutional unit represented by the formula (1-1) is usually 0 to 100% by mol with respect to the total amount of constitutional units contained in the polymer compound, and since the dissolution rate of the polymer compound of the present invention in a solvent is increased, it is preferably 0% by mol or more and 90% by mol or less, more preferably 0% by mol or more and 80% by mol or less, further preferably 0% by mol or more and 70% by mol or less. Further, in the polymer compound of the present invention, the amount of the constitutional unit represented by the formula (1-1) is preferably 5% by mol or more and 90% by mol or less, more preferably 5% by mol or more and 80% by mol or less, further preferably 5% by mol or more and 70% by mol or less, with respect to the total amount of constitutional units contained in the polymer compound, from the standpoint of hole transportability. However, when the amount of the constitutional unit represented by the formula (1-1) with respect to the total amount of constitutional units contained in the polymer compound is 0%, the constitutional unit represented by the formula (1-2) is contained in an amount of 1% or more.

The constitutional unit represented by the formula (1-1) may be contained only singly or in combination of two or more kinds thereof in the polymer compound.

### [Constitutional unit represented by the formula (1-2)]

R^{Y1} is preferably a hydrogen atom or an alkyl group, more preferably a hydrogen atom.

Y is preferably a group represented by -C(R^{Y2})₂-, - C(R^{Y2})=C(R^{Y2})- or -C(R^{Y2})₂-C(R^{Y2})₂-, more preferably a group represented by -C(R^{Y2})₂-.

R^{Y2} is preferably an alkyl group or an aryl group, more preferably an alkyl group.

When a plurality of R^{Y2} are combined together to form a ring together with carbon atoms to which they are attached, the group represented by -C(R^{Y2})₂- is preferably a group represented by the formula (Y-4).

The constitutional unit represented by the formula (1-2) includes, for example, constitutional units represented by the formula (YY-1) to the formula (YY-7), and is preferably a constitutional unit represented by the formula (YY-1) to the formula (YY-5), more preferably a constitutional unit represented by the formula (YY-1) to the formula (YY-3). 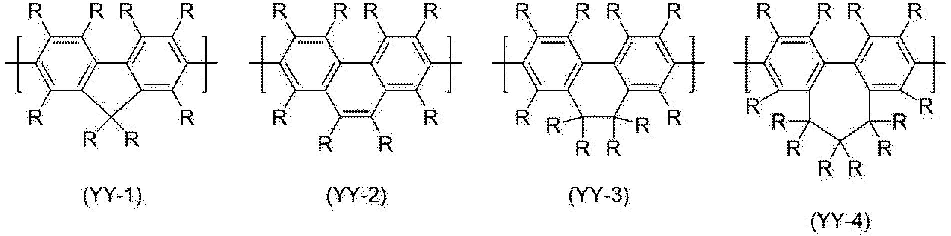 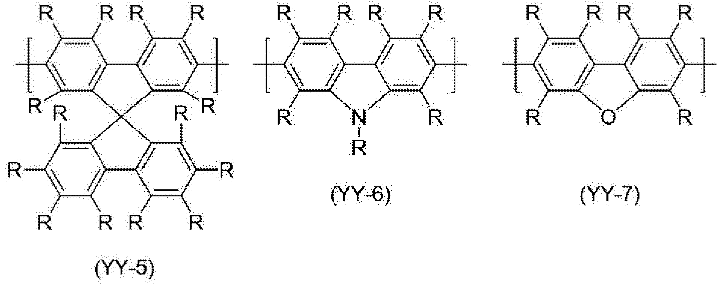 [wherein, R represents the same meaning as described above.]

In the polymer compound of the present invention, the amount of the constitutional unit represented by the formula (1-2) is usually 0 to 100% by mol with respect to the total amount of constitutional units contained in the polymer compound, and since the dissolution rate of the polymer compound of the present invention in a solvent is increased, it is preferably 0% by mol or more and 90% by mol or less, more preferably 0% by mol or more and 80% by mol or less, further preferably 0% by mol or more and 70% by mol or less. Further, in the polymer compound of the present invention, the amount of the constitutional unit represented by the formula (1-2) is preferably 5% by mol or more and 90% by mol or less, more preferably 5% by mol or more and 80% by mol or less, further preferably 5% by mol or more and 70% by mol or less, with respect to the total amount of constitutional units contained in the polymer compound, from the standpoint of electron transportability. However, when the amount of the constitutional unit represented by the formula (1-2) with respect to the total amount of constitutional units contained in the polymer compound is 0%, the constitutional unit represented by the formula (1-1) is contained in an amount of 1% or more.

The constitutional unit represented by the formula (1-2) may be contained only singly or in combination of two or more kinds thereof in the polymer compound.

In the polymer compound of the present invention, when the constitutional unit represented by the formula (1-1) and the constitutional unit represented by the formula (1-2) are contained, the content of the constitutional unit represented by the formula (1-1) and the constitutional unit represented by the formula (1-2) is usually 1 to 100% by mol with respect to the total amount of constitutional units contained in the polymer compound, and since the dissolution rate of the polymer compound of the present invention in a solvent is increased, it is preferably 5% by mol or more and 100% by mol or less, more preferably 10% by mol or more and 100% by mol or less, further preferably 150 by mol or more and 100% by mol or less.

### [Other constitutional unit]

The polymer compound of the present invention may contain "other constitutional unit" other than the constitutional unit represented by the formula (1-1) and the constitutional unit represented by the formula (1-2).

"Other constitutional unit" is a divalent organic group, and the divalent organic group includes divalent groups obtained by directly bonding only one or more divalent aromatic hydrocarbon groups, only one or two divalent hetero ring groups, or at least one divalent aromatic hydrocarbon group and at least one divalent hetero ring group, and the divalent groups obtained by directly bonding the above-described two or more divalent aromatic hydrocarbon groups, the above-described two or more divalent hetero ring groups, or the above-described at least one divalent aromatic hydrocarbon group and the above-described at least one divalent hetero ring group may be bonded directly to form a divalent organic group or may be bonded via at least one group selected from the group consisting of an alkylene group (for example, -(CR₂)-(wherein, R represents the same meaning as described above)), a group represented by -O-, a group represented by -S- and a group represented by -(CO)-, to form a divalent organic group.

Of them, the above-described divalent organic group is preferably a divalent aromatic hydrocarbon group, a divalent hetero ring group, or a divalent group in which at least one divalent aromatic hydrocarbon group and at least one divalent hetero ring group are bonded directly.

"Other constitutional unit" includes, for example, constitutional units represented by the formula (Z-1) to the formula (Z-8), and is preferably a constitutional unit represented by the formula (Z-1) to the formula (Z-6), more preferably a constitutional unit represented by the formula (Z-1) to the formula (Z-4).

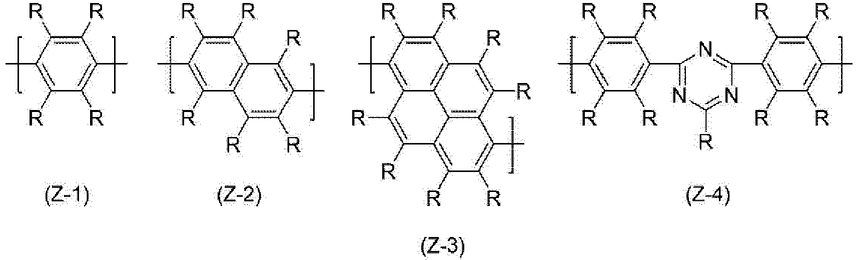

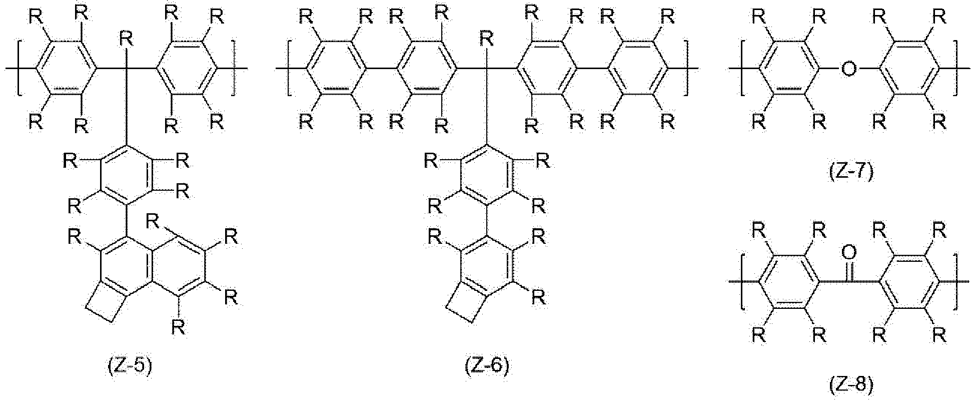

In the polymer compound of the present invention, the amount of "other constitutional unit" is preferably 0 to 90% by mol, more preferably 2 to 80% by mol, further preferably 3 to 70% by mol, with respect to the total amount of constitutional units contained in the polymer compound.

"Other constitutional unit" may be contained only singly or in combination of two or more kinds thereof in the polymer compound.

The polymer compound of the present invention has molecular weight distribution, and has a polystyrene-equivalent weight-average molecular weight (Mw) preferably in a range of 1×10³ to 1×10⁸, more preferably in a range of 1×10⁴ to 1×10⁶, further preferably in a range of 3×10⁴ to 5×10⁵.

The polymer compound of the present invention may be any of a block copolymer, a random copolymer, an alternative copolymer and graft copolymer, and may also be a polymer in other form, and a copolymer obtained by copolymerizing a plurality of raw material monomers is preferable.

The polymer compound of the present invention is preferably a polymer compound having a glass transition temperature of 80°C or higher and 200°C or lower. The glass transition temperature is preferably 85°C or higher, more preferably 90°C or higher, further preferably 95°C or higher, from the standpoint of an increase in the dissolution rate in a solvent. Further, it is preferably 190°C or lower, more preferably 170°C or lower, further preferably 120°C or lower.

The upper limit value and the low limit value described above may be combined arbitrarily.

For example, the above-described glass transition temperature is preferably 85°C or higher and 170°C or lower, more preferably 95°C or higher and 120°C or lower.

### <Production method of polymer compound>

The method of producing a polymer compound of the present invention contains a step 1 of obtaining a mixture containing a polymer compound A containing at least one constitutional unit selected from the group consisting of a constitutional unit represented by the formula (1-1) and a constitutional unit represented by the formula (1-2) and a good solvent for the above-described polymer compound A, a step 2 of mixing the mixture obtained in the step 1 with a poor solvent for said polymer compound at a temperature of 35°C or higher and 75°C or lower, to obtain a precipitate, and a step 3 of removing the precipitate obtained in the step 2.

The above-described precipitate is the polymer compound of the present invention.

The step 1 will be illustrated in detail below. The mixture obtained in the step 1 is referred to as "mixture in step 1".

### [Polymer compound A]

The constitutional unit represented by the formula (1-1) and the constitutional unit represented by the formula (1-2) contained in the polymer compound A each represent the same meaning as described above.

The polymer compound A may contain "other constitutional unit" other than the constitutional unit represented by the formula (1-1) and the constitutional unit represented by the formula (1-2).

"Other constitutional unit" represents the same meaning as described above.

In the polymer compound A, the amount of the constitutional unit represented by the formula (1-1) is usually 0 to 100% by mol with respect to the total amount of constitutional units contained in the polymer compound A, and it is preferably 0% by mol or more and 90% by mol or less, more preferably 0% by mol or more and 80% by mol or less, further preferably 0% by mol or more and 70% by mol or less, since the dissolution rate of the polymer compound of the present invention in a solvent is increased. Further, in the polymer compound A, the amount of the constitutional unit represented by the formula (1-1) is preferably 5% by mol or more and 90% by mol or less, more preferably 5% by mol or more and 80% by mol or less, further preferably 5% by mol or more and 70% by mol or less, with respect to the total amount of constitutional units contained in the polymer compound A, from the standpoint of hole transportability of the polymer compound of the present invention. However, when the amount of the constitutional unit represented by the formula (1-1) with respect to the total amount of constitutional units contained in the polymer compound A is 0%, the constitutional unit represented by the formula (1-2) is contained in an amount of 1% or more.

The constitutional unit represented by the formula (1-1) may be contained only singly or in combination of two or more kinds thereof in the polymer compound A.

In the polymer compound A, the amount of the constitutional unit represented by the formula (1-2) is usually 0 to 100% by mol with respect to the total amount of constitutional units contained in the polymer compound A, and since the dissolution rate of the polymer compound of the present invention in a solvent is increased, it is preferably 0% by mol or more and 90% by mol or less, more preferably 0% by mol or more and 80% by mol or less, further preferably 0% by mol or more and 70% by mol or less. Further, in the polymer compound A, the amount of the constitutional unit represented by the formula (1-2) is preferably 5% by mol or more and 90% by mol or less, more preferably 5% by mol or more and 80% by mol or less, further preferably 5% by mol or more and 70% by mol or less, with respect to the total amount of constitutional units contained in the polymer compound A, from the standpoint of electron transportability of the polymer compound of the present invention. However, when the amount of the constitutional unit represented by the formula (1-2) with respect to the total amount of constitutional units contained in the polymer compound A is 0%, the constitutional unit represented by the formula (1-1) is contained in an amount of 1% or more.

The constitutional unit represented by the formula (1-2) may be contained only singly or in combination of two or more kinds thereof in the polymer compound A.

In the polymer compound A, when the constitutional unit represented by the formula (1-1) and the constitutional unit represented by the formula (1-2) are contained, the content of the constitutional unit represented by the formula (1-1) and the constitutional unit represented by the formula (1-2) is usually 1 to 100% by mol, with respect to the total amount of constitutional units contained in the polymer compound A, and since the dissolution rate of the polymer compound of the present invention in a solvent is increased, the content is preferably 5% by mol or more and 100% by mol or less, more preferably 10% by mol or more and 100% by mol or less, further preferably 15% by mol or more and 100% by mol or less.

In the polymer compound A, the amount of "other constitutional unit" is preferably 0 to 90% by mol, more preferably 2 to 80% by mol, further preferably 3 to 70% by mol, with respect to the total amount of constitutional units contained in the polymer compound A.

The other constitutional unit may be contained only singly or in combination of two or more kinds thereof in the polymer compound A.

The polymer compound A has molecular weight distribution, and has a polystyrene-equivalent weight-average molecular weight (Mw) preferably in a range of 1×10³ to 1×10⁸, more preferably in a range of 1×10⁴ to 1×10⁶, further preferably in a range of 3×10⁴ to 5×10⁵.

The polymer compound A may be any of a block copolymer, a random copolymer, an alternate copolymer or a graft copolymer, and may also be a copolymer in other form, and a copolymer obtained by copolymerizing a plurality of raw material monomers is preferable.

The polymer compound A can be obtained, for example, by polymerizing a monomer containing a chlorine atom or a bromine atom. The polymerization method include a method of polymerizing a monomer by a Suzuki coupling reaction, a method of polymerization by a Buchwald coupling reaction, a method of polymerization by a Stille coupling reaction, a method of polymerization by a Kumada coupling reaction, a method of polymerization by a Yamamoto coupling reaction and the like. Of them, a method of polymerization by a Suzuki coupling reaction and a method of polymerization by a Buchwald coupling reaction are preferable from the viewpoint of easy control of the structure of the polymer compound A.

When the purity of the polymer compound A is low, it may be purified by a usual method such as liquid-separation, recrystallization, reprecipitation, column chromatography, Soxhlet washing or the like, if necessary.

### [Good solvent]

The good solvent is a solvent in which the polymer compound A can be dissolved without decomposing the polymer compound A, and a solvent in which the solubility of the polymer compound A is 1g (polymer compound A)/100g (good solvent) or more at 20°C is used.

The good solvent includes, for example, aromatic hydrocarbon solvents such as toluene, xylene, mesitylene, cyclohexylbenzene, tetralin and the like; ether solvents such as tetrahydrofuran, 1,4-dioxane, dimethoxyethane, anisole and the like; ketone solvents such as acetone, methyl ethyl ketone, cyclopentanone, cyclohexanone, methyl amyl ketone, methyl isobutyl ketone and the like; aliphatic hydrocarbon solvents such as pentane, hexane, heptane and the like; halogenated hydrocarbon solvents such as chloroform, chlorobenzene and the like; etc. Of them, aromatic hydrocarbon solvents and ether solvents are preferable, aromatic hydrocarbon solvents are more preferable, toluene, xylene and mesitylene are further preferable.

As the good solvent, one type of solvent may be used, or two types of solvents may be used.

The content of the good solvent in the mixture in the step 1 is usually 100 to 1000000 parts by weight, preferably 500 to 100000 parts by weight, with respect to 100 parts by weight of the polymer compound A.

The step 2 will be illustrated in detail below.

### [Poor solvent]

The poor solvent is a solvent in which the polymer compound A is difficult to dissolve without decomposing the polymer compound A, and a solvent in which the solubility of the polymer compound A is less than 1g (polymer compound A)/100g (poor solvent) at 20°C is used.

The above-described poor solvent includes, for example, water; amide solvents such as N,N-dimethylacetamide, N,N-dimethylformamide and the like; alcohol solvents such as methanol, ethanol, isopropanol, ethylene glycol, isopropyl alcohol, propylene glycol and the like; nitrile solvents such as acetonitrile and the like; ester solvents such as methyl acetate, ethyl acetate and the like; etc. Of them, alcohol solvents are preferable, methanol, ethanol and isopropanol are more preferable, methanol is further preferable.

As the above-described poor solvent, one type of solvent may be used, or two types of solvents may be used.

The temperature of the above-described poor solvent is preferably 40°C or higher. Further, it is preferably 70°C or lower, more preferably 65°C or lower, further preferably 60°C or lower. When the mixture obtained in step 1 and the poor solvent are mixed, the dissolution rate of the polymer compound of the present invention in the solvent is increased by using the poor solvent in the above range.

The upper limit value and the low limit value described above may be combined arbitrarily.

For example, the temperature of the above-described poor solvent is preferably 40°C or higher and 60°C or lower.

The use amount of the poor solvent is usually 100 to 10000 parts by weight, preferably 200 to 5000 parts by weight, more preferably 300 to 2000 parts by weight, with respect to 100 parts by weight of the above-described good solvent.

In the step 2, if the mixture in the step 1 and the poor solvent are mixed, a polymer compound of the present invention precipitates.

In the step 2, the mixing
(a) may be adding the mixture in the step 1 to the above-described poor solvent and mixing them,
(b) may be adding the above-described poor solvent to the mixture in the step 1 and mixing them, or
(c) may be adding the mixture in the step 1 and the poor solvent into one vessel simultaneously and mixing them.

Of them, the above-described (a) is preferable, and it is preferable that the above-described (a) is performed in the state where the above-described poor solvent is being stirred. In the above-described (a), the rate of adding the mixture in the step 1 to the above-described poor solvent is usually 1 g/min to 10000000 g/min, and since the dissolution rate of the polymer compound of the present invention in a solvent is increased, it is preferably 10 g/min to 1000000 g/min.

The above-described stirring time is usually 1 minute to 10 hours, preferably 10 minutes to 2 hours.

The stirring method includes methods using, for example, a combination of an electric stirrer and a stirring blade, a combination of an air motor stirrer and a stirring blade, a combination of a magnet stirrer and a stirring blade, a combination of a magnet stirrer and a stirrer, or the like.

The stirring power in the above-described stirring is preferably 0.01 kW/m³ or more, more preferably 0.05 kW/m³ or more, further preferably 0.2 kW/m³ or more, since the dissolution rate of the polymer compound of the present invention in a solvent is increased. Further, it is preferably 5.0 kW/m³ or less, more preferably 3.0 kW/m³ or less, further preferably 1.0 kW/m³ or less.

In the step 2, the temperature of the mixture in the step 1 in mixing the mixture in the step 1 and the above-described poor solvent is usually -20°C to 100°C, preferably 0°C to 75°C, more preferably 0°C to 30°C.

The step 3 will be illustrated in detail below.

The step 3 is a step of removing the precipitate that is the polymer compound of the present invention in the step 2. An example of the method for removing the precipitate is filtration. The precipitate extracted by filtration may be washed with the poor solvent.

The above-described precipitate may be dried, if necessary, to remove a good solvent and/or a poor solvent contained in the precipitate. Examples of the drying method include a heating method, a decompression method, an air drying method, and a combination thereof.

### <Light emitting device>

The light emitting device of the present embodiment is a light emitting device having an anode, a cathode, and an organic layer, and is a light emitting device having the organic layer between the anode and the cathode, and is a light emitting device containing a film formed by using the polymer compound of the present invention in the above-described organic layer. Examples of the organic layer include a light emitting layer, a hole transporting layer, a hole injection layer, an electron transporting layer, an electron injection layer and the like. At least one of these layers is a film formed using the polymer compound of the present invention.

The polymer compound of the present invention may contain a group having a chemical structure such as benzocyclobutene, alkene, epoxy or oxetane which forms a crosslinked structure by a crosslinking reaction (hereinafter, referred to as a crosslinking group), and after forming the film using the polymer compound having the crosslinkable group, the crosslinking group can be cross-linked to insolubilize the film. By insolubilizing the film in this manner, even when the material of the film is dissolved in a solvent used when forming the layer adjacent to the organic layer composed of the film, in the light emitting device, dissolution of the material can be avoided.

The organic layer included in the light emitting device of the embodiment of the present application may be a film containing the polymer compound of the present invention, which is formed without through the step of insolubilizing the film by crosslinking described above.

### [Layer constitution]

The film containing the polymer compound of the present invention is generally one or more layers selected from the group consisting of a light emitting layer, a hole transporting layer, a hole injection layer, an electron transporting layer and an electron injection layer, and is preferably a hole transporting layer.

These layers contain a light emitting material, a hole transporting material, a hole injection material, an electron transporting material, and an electron injection material, respectively. These layers can be formed by dissolving a light emitting material, a hole transporting material, a hole injecting material, an electron transporting material and an electron injection material in the above-described good solvent, to prepare inks, and using a usual film fabrication method such as a spin coating method.

The light emitting device has a light emitting layer between an anode and a cathode. The light emitting device of the present embodiment preferably has at least one of a hole injection layer and a hole transporting layer between the anode and the light emitting layer, from the viewpoint of the hole injectability and the hole transportablity, and it is preferable that at least of an electron injection layer and an electron transporting layer is provided between the cathode and the light emitting layer from the viewpoint of the electron injectability and the electron transportability.

As materials for the hole transporting layer, the electron transporting layer, the light emitting layer, the hole injection layer and the electron injection layer, a hole transporting material, an electron transporting material, a light emitting material, a hole injection material and an electron injection material may be included, in addition to the materials contained in the film containing the polymer compound of the present invention.

If the material for the hole transporting layer, the material for the electron transporting layer and the material for the light emitting layer are dissolved in a solvent used in forming layers adjacent to the hole transporting layer, the electron transporting layer and the light emitting layer in fabrication of a light emitting device, it is preferable that the materials have a crosslinking group to avoid dissolution of the materials in the solvent. After forming each of the layers using materials having a crosslinking group, the crosslinkinig group can be cross-linked to insolubilized the layers.

In a method for forming each layer such as a light emitting layer, a hole transporting layer, an electron transporting layer, a hole injection layer and an electron injection layer, in the light emitting device of the present embodiment, for example, a vapor deposition method from powder and a method of forming a film from a solution or a molten state are mentioned when a low molecular compound is used, and a method of forming a film from a solution or a molten state is mentioned when a polymer compound is used. The order, number and thickness of the layers to be laminated are adjusted in consideration of light emitting efficiency and luminance life.

### [Substrate/electrode]

The substrate in the light emitting device may advantageously be a substrate on which an electrode can be formed and which does not change chemically in forming an organic layer, and is, for example, a substrate made of a material such as glass, plastic, silicon and the like. When an opaque substrate is used, it is preferable that the electrode farthest from the substrate is transparent or semi-transparent.

The material of the anode includes, for example, electrically conductive metal oxides and semi-transparent metals, preferably includes indium oxide, zinc oxide, tin oxide; electrically conductive compounds such as indium-tin-oxide (ITO), indium-zinc-oxide and the like; argentine-palladium-copper (APC) complex; NESA, gold, platinum, silver and copper.

The material of the cathode includes, for example, metals such as lithium, sodium, potassium, rubidium, cesium, beryllium, magnesium, calcium, strontium, barium, aluminum, zinc, indium and the like; alloys composed of two or more of them; alloys composed of at least one of them and at least one of silver, copper, manganese, titanium, cobalt, nickel, tungsten and tin; and graphite and graphite intercalation compounds. The alloy includes, for example, a magnesium-silver alloy, a magnesium-indium alloy, a magnesium-aluminum alloy, an indium-silver alloy, a lithium-aluminum alloy, a lithium-magnesium alloy, a lithium-indium alloy and a calcium-aluminum alloy.

Each of the anode and the cathode may have a laminated structure composed of two or more layers.

### [Application]

The light emitting device of this embodiment can be used for displays of computers, televisions, mobile terminals, and the like. The planar light emitting device can be suitably used as a planar light source for a backlight of a liquid crystal display device or a planar illumination light source. If a flexible substrate is used, it can be used as a curved light source and a display device.

### EXAMPLES

Hereinafter, examples will be shown in order to explain the present invention in further detail, but the present invention is not limited to these.

### <Analysis of molecular weight>

The polystyrene-equivalent weight-average molecular weight (Mw), the polystyrene-equivalent number-average molecular weight (Mn) and the polydispersity (Mw/Mn) of a polymer compound were determined by gel permeation chromatography (GPC). The analysis conditions are as described below.
Measurement apparatus: HLC-8320GPC (manufactured by Tosoh Corp.)
Column: PLgel 10 µm MIXED-B (manufactured by Tosoh Corp.)
Column temperature: 40°C
Mobile phase: tetrahydrofuran
Flor rate: 0.5 mL/min
Detection wavelength: 228 nm

### <Measurement of tap density>

The measurement of the tap density of the polymer compound was performed as follows.

First, a measuring cylinder having a volume of 100 mL was prepared, 2 g of the polymer compound was put in the measuring cylinder, and the volume of the polymer compound was measured. Next, the measuring cylinder was placed on a flat table, the measuring cylinder was lifted by 1 cm vertically from the table by hand, and the hand was released to allow the measuring cylinder to drop naturally toward the table from its height, and these procedures were repeated 10 times as one tap operation. The reduction ratio of the volume value of the polymer compound after one tap operation with respect to the volume value of the polymer compound before the tap operation was calculated. When the reduction ratio was over 5%, the tap operation was performed again, and the reduction ratio of the volume value of the polymer compound after two tap operations with respect to the volume value of the polymer compound after one tap operation was calculated. The tap operation was repeated until the reduction ratio became 5% or less.

The tap density (g/cm³) was obtained by dividing the mass (2 g) of the polymer compound by the volume value (B) of the polymer compound in which the reduction ratio was 5% or less.

Tap density (g/cm³) = mass (2 g) of polymer compound/volume value (B) of polymer compound

### <Measurement of glass transition temperature>

The glass transition temperature was determined by differential scanning calorimeter (DSC). The analysis conditions are as described below.
Measurement apparatus: DSC Q2000 (manufactured by TA Instruments)
Temperature condition: equilibrated at 0°C → raising temperature at 20°C/min → 300°C

### <Evaluation of dissolution rate of polymer compound in solvent>

The dissolution rate of the polymer compounds produced in Examples 1 to 6 and Comparative Examples 1 to 4 in a solvent was evaluated by the following method.

The polymer compound (0.050 g) and the solvent (5.0 g) were mixed and stirred at 23°C. The time until complete dissolution (hereinafter, referred to as dissolution time) was measured. The container was a cylindrical shape having a diameter of 2.0 cm, and a stirrer having a diameter of 1.0 cm was stirred at 200 rpm. Dissolution of the polymer compound was visually confirmed. As the solvent, toluene, anisole, cyclohexylbenzene, or a mixed solvent of toluene and 1,2-dimethoxybenzene was used.

It can be evaluated that the shorter the above-mentioned dissolution time is, the higher the dissolution rate of the polymer compound in the solvent is.

### <Synthesis Example 1>

An inert gas atmosphere was prepared in a reaction vessel, then, the compound M1 (21.05 g), the compound M2 (10.93 g), the compound M3 (5.51 g), the compound M4 (3.81 g), dichlorobis(triphenylphosphine)palladium (11.80 mg), toluene (403 g) and a 20% by mass tetraethylammonium hydroxide aqueous solution (250 g) were added, and the solution was refluxed for 3 hours. To the resultant reaction liquid was added toluene, to prepare a 1% by mass toluene solution of the polymer compound PA, then, the solution was liquid-separated and the aqueous layer was removed, and liquid-separated and washed with a hydrochloric acid aqueous solution, an ammonia aqueous solution and water in this order. The resultant solution was allowed to pass through silica gel, to obtain 3 kg of a toluene solution of the polymer compound PA. The resultant solution contained 10000 parts by weight of toluene with respect to 100 parts by weight of the polymer compound PA, and the polymer compound PA in the solution had Mw/Mn = 2.3 and Mw = 7.5×10⁴. n represents the degree of polymerization.

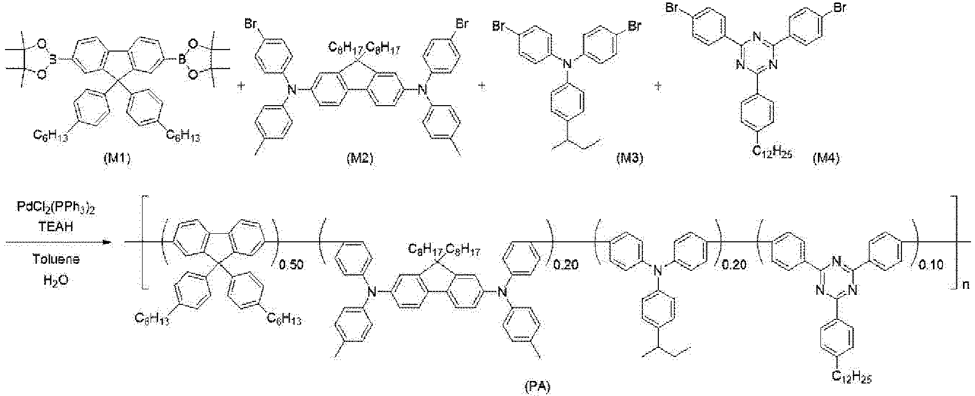

### <Example 1>

The solution obtained in Synthesis Example 1 (25°C, 100 g) was added dropwise into 600 g of methanol of 50°C while stirring at 0.3 kW/m³ over a period of 1 minute, and further stirred at 50°C for 30 minutes, then, a precipitate was obtained. The resultant precipitate was filtrated and dried to obtain a polymer compound P1. The tap density of the polymer compound P1 measured by the above method was 0.09 g/cm³. Further, the polymer compound P1 had a glass transition temperature of 112°C, Mw/Mn = 2.3, and Mw = 7.6 × 10⁴.

### <Example 2>

The solution obtained in Synthesis Example 1 (25°C, 100 g) was added dropwise into 600 g of methanol of 60°C while stirring at 0.3 kW/m³ over a period of 1 minute, and further stirred at 60°C for 30 minutes, then, a precipitate was obtained. The resultant precipitate was filtrated and dried to obtain a polymer compound P2. The tap density of the polymer compound P2 measured by the above method was 0.06 g/cm³. Further, the polymer compound P2 had a glass transition temperature of 112°C, Mw/Mn = 2.3, and Mw = 7.6 × 10⁴.

### <Example 3>

The solution obtained in Synthesis Example 1 (25°C, 100 g) was added dropwise into 600 g of 1-butanol of 70°C while stirring at 0.3 kW/m³ over a period of 1 minute, and further stirred at 70°C for 30 minutes, then, a precipitate was obtained. The resultant precipitate was filtrated and dried to obtain a polymer compound P3. The tap density of the polymer compound P3 measured by the above method was 0.10 g/cm³. Further, the polymer compound P3 had a glass transition temperature of 112°C, Mw/Mn = 2.2, and Mw = 7.6 × 10⁴.

### <Comparative Example 1>

The solution obtained in Synthesis Example 1 (25°C, 100 g) was added dropwise into 600 g of methanol of 25°C while stirring at 0.3 kW/m³ over a period of 1 minute, and further stirred at 25°C for 30 minutes, then, a precipitate was obtained. The resultant precipitate was filtrated and dried to obtain a polymer compound P4. The tap density of the polymer compound P4 measured by the above method was 0.15 g/cm³. Further, the polymer compound P4 had a glass transition temperature of 112°C, Mw/Mn = 2.3, and Mw = 7.6 × 10⁴.

### <Comparative Example 2>

The solution obtained in Synthesis Example 1 (25°C, 100 g) was added dropwise into 600 g of 1-butanol of 80°C while stirring at 0.3 kW/m³ over a period of 1 minute, and further stirred at 80°C for 30 minutes, then, a precipitate was obtained. The resultant precipitate was filtrated and dried to obtain a polymer compound P5. The tap density of the polymer compound P5 measured by the above method was 0.17 g/cm³. Further, the polymer compound P5 had a glass transition temperature of 112°C, Mw/Mn = 2.3, and Mw = 7.6 × 10⁴.

### <Synthesis Example 2>

An inert gas atmosphere was prepared in a reaction vessel, then, the compound M5 (17.22 g), the compound M6 (1.04 g), the compound M7 (1.94 g), the compound M8 (14.09 g), dichlorobis(triphenylphosphine)palladium (14.30 mg), toluene (269 g) and a 20% by mass tetraethylammonium hydroxide aqueous solution (167 g) were added, and the solution was refluxed for 3 hours. To the resultant reaction liquid was added toluene to prepare a 1% by mass toluene solution of the polymer compound PB, then, the solution was liquid-separated and the aqueous layer was removed, and liquid-separated and washed with a hydrochloric acid aqueous solution, an ammonia aqueous solution and water in this order. The toluene solution of the resultant polymer compound PB was allowed to pass through silica gel, to obtain 2 kg of a toluene solution of the polymer compound PB. The resultant solution contained 10000 parts by weight of toluene with respect to 100 parts by weight of the polymer compound PB, and the polymer compound PB in the solution had Mw/Mn = 3.1 and Mw = 1.4×10⁵. n represents the degree of polymerization.

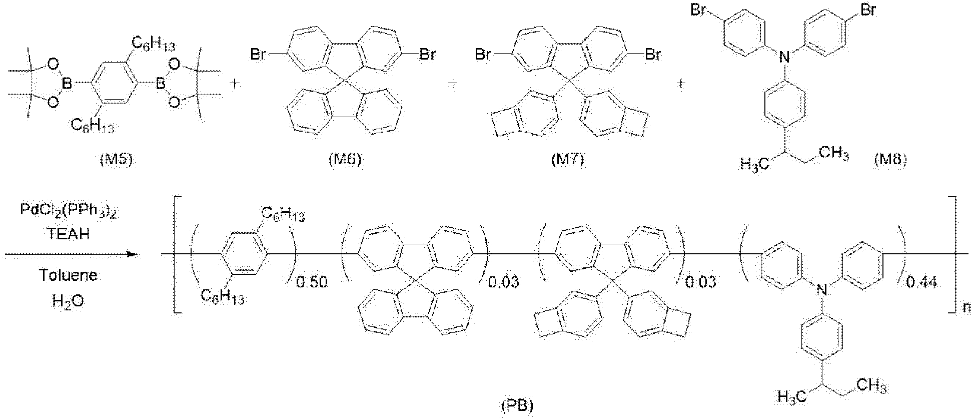

### <Example 4>

The solution obtained in Synthesis Example 2 (25°C, 100 g) was added dropwise into 600 g of methanol of 40°C while stirring at 0.3 kW/m³ over a period of 1 minute, and further stirred at 40°C for 30 minutes, then, a precipitate was obtained. The resultant precipitate was filtrated and dried to obtain a polymer compound P6. The tap density of the polymer compound P6 measured by the above method was 0.06 g/cm³. Further, the polymer compound P6 had a glass transition temperature of 118°C, Mw/Mn = 3.1, and Mw = 1.4 × 10⁵.

### <Example 5>

The solution obtained in Synthesis Example 2 (25°C, 100 g) was added dropwise into 600 g of methanol of 50°C while stirring at 0.3 kW/m³ over a period of 1 minute, and further stirred at 50°C for 30 minutes, then, a precipitate was obtained. The resultant precipitate was filtrated and dried to obtain a polymer compound P7. The tap density of the polymer compound P7 measured by the above method was 0.05 g/cm³. Further, the polymer compound P7 had a glass transition temperature of 118°C, Mw/Mn = 3.1, and Mw = 1.4 × 10⁵.

### <Example 6>

The solution obtained in Synthesis Example 2 (25°C, 100 g) was added dropwise into 600 g of methanol of 60°C while stirring at 0.3 kW/m³ over a period of 1 minute, and further stirred at 60°C for 30 minutes, then, a precipitate was obtained. The resultant precipitate was filtrated and dried to obtain a polymer compound P8. The tap density of the polymer compound P8 measured by the above method was 0.08 g/cm³. Further, the polymer compound P8 had a glass transition temperature of 118°C, Mw/Mn = 3.1, and Mw = 1.4 × 10⁵.

### <Comparative Example 3>

The solution obtained in Synthesis Example 2 (25°C, 100 g) was added dropwise into 600 g of methanol of 25°C while stirring at 0.3 kW/m³ over a period of 1 minute, and further stirred at 25°C for 30 minutes, then, a precipitate was obtained. The resultant precipitate was filtrated and dried to obtain a polymer compound P9. The tap density of the polymer compound P9 measured by the above method was 0.14 g/cm³. Further, the polymer compound P9 had a glass transition temperature of 118°C, Mw/Mn = 3.1, and Mw = 1.4 × 10⁵.

### <Comparative Example 4>

The solution obtained in Synthesis Example 1 (25°C, 100 g) was added dropwise into 600 g of 1-butanol of 80°C while stirring at 0.3 kW/m³ over a period of 1 minute, and further stirred at 80°C for 30 minutes, then, a precipitate was obtained. The resultant precipitate was filtrated and dried to obtain a polymer compound P10. The tap density of the polymer compound P10 measured by the above method was 0.18 g/cm³. Further, the polymer compound P10 had a glass transition temperature of 118°C, Mw/Mn = 3.1, and Mw = 1.4 × 10⁵.

<Evaluation of dissolution rate of polymer compound in solvent>

With respect to the polymer compounds P1 to P5 obtained in Examples 1 to 3 and Comparative Examples 1 and 2, the dissolution rates in respective solvents such as toluene, anisole and cyclohexylbenzene were evaluated according to the above-described evaluation methods. The results are shown below.

**[Table 1]**

| | polymer compound | mixing temperature (°C) | tap density (g/cm³) | dissolution time (sec) | | |
|---|---|---|---|---|---|---|
| | | | | toluene | anisole | cyclohexylbenzene |
| Example 1 | P1 | 50 | 0.09 | 50 | 180 | 1200 |
| Example 2 | P2 | 60 | 0.06 | 20 | 60 | 330 |
| Example 3 | P3 | 70 | 0.10 | 60 | 220 | 900 |
| Comparative Example 1 | P4 | 25 | 0.15 | 600 | 900 | 3600 |
| Comparative Example 2 | P5 | 80 | 0.17 | 600 | 850 | 3000 |

With respect to the polymer compounds P6 to P10 obtained in Examples 4 to 6 and Comparative Examples 3 and 4, the dissolution rates in a mixed solvent of toluene and 1,2-dimethoxybenzene or in toluene were evaluated according to the evaluation method described above. However, as the mixed solvent, a mixed solvent in which the mass ratio of toluene to 1,2-dimethoxybenzene was 1/1 was used.

The results are shown below.

**[Table 2]**

| | polymer compound | mixing temperature (°C) | tap density (g/cm³) | dissolution time (sec) | |
|---|---|---|---|---|---|
| | | | | toluene | toluene/1,2-dimethoxybenzene |
| Example 4 | P6 | 40 | 0.06 | 160 | 330 |
| Example 5 | P7 | 50 | 0.05 | 100 | 360 |
| Example 6 | P8 | 60 | 0.08 | 150 | 340 |
| Comparative Example 3 | P9 | 25 | 0.14 | 560 | 1200 |
| Comparative Example 4 | P10 | 80 | 0.18 | 600 | 1100 |

## Claims

1. A polymer compound consisting of:
(i) at least one constitutional unit selected from the group consisting of a constitutional unit represented by the following formula (1-1) and a constitutional unit represented by the following formula (1-2),
wherein the constitutional unit represented by the formula (1-1) may be contained only singly or in combination of two or more kinds thereof, and the constitutional unit represented by the formula (1-2) may be contained only singly or in combination of two or more kinds thereof;
and, optionally,
(ii) at least one other constitutional unit that is a divalent organic group obtained by directly bonding only one or more divalent aromatic hydrocarbon groups, only one or two divalent hetero ring groups, or at least one divalent aromatic hydrocarbon group and at least one divalent hetero ring group, and the divalent groups obtained by directly bonding the two or more divalent aromatic hydrocarbon groups, the two or more divalent hetero ring groups, or the at least one divalent aromatic hydrocarbon group and the at least one divalent hetero ring group may be bonded directly to form a divalent organic group or may be bonded via at least one group selected from the group consisting of an alkylene group, a group represented by -O-, a group represented by -S- and a group represented by -(CO)-, to form a divalent organic group,
wherein said other constitutional unit may be contained only singly or in combination of two or more kinds thereof;
wherein the tap density is 0.02 g/cm³ or more and 0.13 g/cm³ or less: 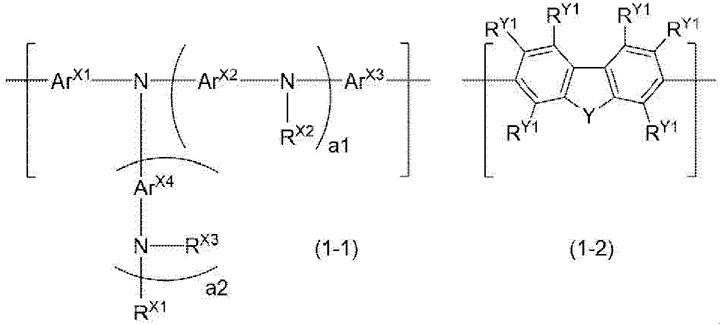 in the formula (1-1),
a1 and a2 each independently represent an integer of 0 or more and 2 or less,
Ar^{X1} represents a direct bond, a divalent aromatic hydrocarbon group, a divalent hetero ring group, or a divalent group in which at least one divalent aromatic hydrocarbon group and at least one divalent hetero ring group are bonded directly, and the foregoing groups optionally have a substituent,
Ar^{X2}, Ar^{X3} and Ar^{X4} each independently represent a divalent aromatic hydrocarbon group, a divalent hetero ring group, or a divalent group in which at least one divalent aromatic hydrocarbon group and at least one divalent hetero ring group are bonded directly, and the foregoing groups optionally have a substituent, and when a plurality of Ar^{X2} and Ar^{X4} are present, they may be the same or different at each occurrence,
R^{X1}, R^{X2} and R^{X3} each independently represent an alkyl group, an aryl group or a monovalent hetero ring group, and the foregoing groups optionally have a substituent, and when a plurality of R^{X2} and R^{X3} are present, they may be the same or different at each occurrence,
in the formula (1-2),
R^{Y1} represents a hydrogen atom, an alkyl group, an aryl group or a monovalent hetero ring group, and the foregoing groups optionally have a substituent, a plurality of R^{Y1} may be the same or different,
Y represents a group represented by -C(R^{Y2})₂-, - C(R^{Y2})=C(R^{Y2})-, -C(R^{Y2})₂-C(R^{Y2})₂-, -C(R^{Y2})₂-C(R^{Y2})₂-C(R^{Y2})₂-, -N(R^{Y2})- or -O-,
R^{Y2} represents a hydrogen atom, an alkyl group, an alkoxy group, an aryl group or a monovalent hetero ring group, and the foregoing groups optionally have a substituent, and when a plurality of R^{Y2} are present, they may be the same or different, and the plurality of R^{Y2} may be combined together to form a ring together with carbon atoms to which they are attached, and when the plurality of R^{Y2} form a ring, the group represented by -C(R^{Y2})₂- is a group represented by the formula (Y-1) to the formula (Y-5), and the foregoing groups optionally have a substituent:

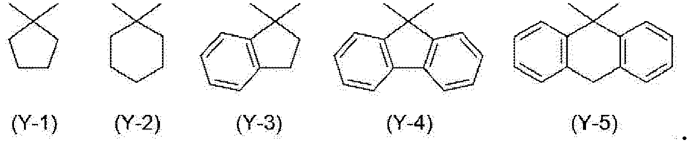

2. The polymer compound according to Claim 1, wherein the glass transition temperature is 80°C or higher and 200°C or lower.

3. The polymer compound according to Claim 1 or 2, wherein the content of the constitutional unit represented by the formula (1-1) and the constitutional unit represented by the formula (1-2) is 1 to 100% by mol with respect to the total amount of constitutional units contained in the polymer compound.

4. The polymer compound according to any one of Claims 1 to 3, wherein the amount of the constitutional unit represented by the formula (1-1) is 5% by mol or more and 90% by mol or less with respect to the total amount of constitutional units contained in the polymer compound.

5. The polymer compound according to any one of Claims 1 to 4, wherein the amount of the constitutional unit represented by the formula (1-2) is 5% by mol or more and 90% by mol or less with respect to the total amount of constitutional units contained in the polymer compound.

6. The polymer compound according to any one of Claims 1 to 5, wherein the polymer compound has a polystyrene-equivalent weight-average molecular weight, Mw, in a range of 1×10³ to 1×10⁸.

7. A method of producing a polymer compound as defined in any one of Claims 1 to 6, the method comprising a step of mixing a mixture containing:
(A) a polymer compound consisting of: (i) and (ii) as defined in Claim 1 and
(B) a good solvent for said polymer compound;
with a poor solvent for said polymer compound at a temperature of 35°C or higher and 75°C or lower and removing the resultant precipitate,
wherein
the good solvent is a solvent in which said polymer compound can be dissolved without decomposing the polymer compound, and a solvent in which the solubility of said polymer compound is 1g polymer compound / 100g good solvent or more at 20°C, and
the poor solvent is a solvent in which said polymer compound is difficult to dissolve without decomposing the polymer compound, and a solvent in which the solubility of said polymer compound is less than 1g polymer compound / 100g poor solvent at 20°C.

8. The production method according to Claim 7, wherein said good solvent is an aromatic hydrocarbon.

9. The production method according to Claim 7 or 8,
wherein the amount of said poor solvent is 300 parts by weight or more with respect to 100 parts by weight of said good solvent.

10. A light emitting device comprising an anode, a cathode, and an organic layer formed by using the polymer compound according to any one of Claims 1 to 6 disposed between said anode and said cathode.

## Patentansprüche

1. Polymerverbindung, bestehend aus:
(i) wenigstens einer konstitutionellen Einheit, ausgewählt aus der Gruppe, bestehend aus einer konstitutionellen Einheit, dargestellt durch die folgende Formel (1-1), und einer konstitutionellen Einheit, dargestellt durch die folgende Formel (1-2),
wobei die durch die Formel (1-1) dargestellte konstitutionelle Einheit nur einzeln oder in Kombination von zwei oder mehr Arten davon enthalten sein kann, und die durch die Formel (1-2) dargestellte konstitutionelle Einheit nur einzeln oder in Kombination von zwei oder mehr Arten davon enthalten sein kann,
und, optional,
(ii) wenigstens eine andere konstitutionelle Einheit, die eine zweiwertige organische Gruppe ist, die durch direkte Bindung von nur einer oder mehreren zweiwertigen aromatischen Kohlenwasserstoffgruppen, nur einer oder zwei zweiwertigen Heteroringgruppen oder wenigstens einer zweiwertigen aromatischen Kohlenwasserstoffgruppe und wenigstens einer zweiwertigen Heteroringgruppe erhalten wird, und die zweiwertigen Gruppen, die durch direkte Bindung der zwei oder mehr zweiwertigen aromatischen Kohlenwasserstoffgruppen, der zwei oder mehr zweiwertigen Heteroringgruppen oder der wenigstens einen zweiwertigen aromatischen Kohlenwasserstoffgruppe und der wenigstens einen zweiwertigen Heteroringgruppe erhalten werden, direkt gebunden werden können, um eine zweiwertige organische Gruppe auszubilden, oder über wenigstens eine Gruppe, ausgewählt aus der Gruppe, bestehend aus einer Alkylengruppe, einer Gruppe, dargestellt durch -O-, einer Gruppe, dargestellt durch -S- und einer Gruppe, dargestellt durch -(CO)-, gebunden werden können, um eine zweiwertige organische Gruppe auszubilden,
wobei die andere konstitutionelle Einheit nur einzeln oder in Kombination von zwei oder mehr Arten davon enthalten sein kann,
wobei die Klopfdichte 0,02 g/cm³ oder mehr und 0,13 g/cm³ oder weniger beträgt: 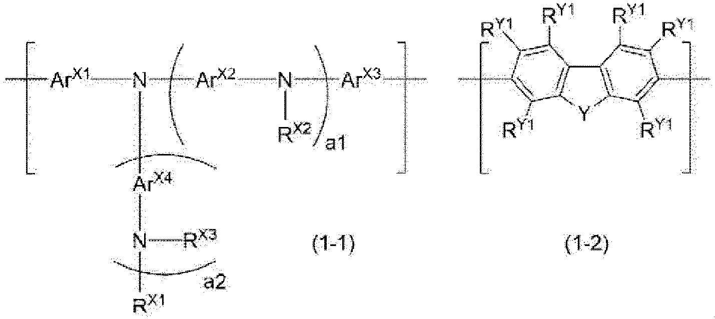 in der Formel (1-1),
a1 und a2 jeweils unabhängig voneinander eine ganze Zahl von 0 oder mehr und 2 oder weniger darstellen,
Ar^{X1} eine direkte Bindung, eine zweiwertige aromatische Kohlenwasserstoffgruppe, eine zweiwertige Heteroringgruppe oder eine zweiwertige Gruppe darstellt, in der wenigstens eine zweiwertige aromatische Kohlenwasserstoffgruppe und wenigstens eine zweiwertige Heteroringgruppe direkt gebunden sind, und die vorgenannten Gruppen optional einen Substituenten aufweisen,
Ar^{X2}, Ar^{X3} und Ar^{X4} jeweils unabhängig voneinander eine zweiwertige aromatische Kohlenwasserstoffgruppe, eine zweiwertige Heteroringgruppe oder eine zweiwertige Gruppe darstellen, in der wenigstens eine zweiwertige aromatische Kohlenwasserstoffgruppe und wenigstens eine zweiwertige Heteroringgruppe direkt gebunden sind, und die vorgenannten Gruppen optional einen Substituenten aufweisen, und wenn eine Mehrzahl von Ar^{X2} und Ar^{X4} vorhanden sind, können sie bei jedem Auftreten gleich oder verschieden sein,
R^{X1}, R^{X2} und R^{X3} jeweils unabhängig voneinander für eine Alkylgruppe, eine Arylgruppe oder eine einwertige Heteroringgruppe darstellen, und die vorgenannten Gruppen optional einen Substituenten aufweisen, und wenn eine Mehrzahl von R^{X2} und R^{X3} vorhanden ist, sie bei jedem Auftreten gleich oder verschieden sein können,
in der Formel (1-2),
R^{Y1} ein Wasserstoffatom, eine Alkylgruppe, eine Arylgruppe oder eine einwertige Heteroringgruppe darstellt, und die vorgenannten Gruppen optional einen Substituenten aufweisen, wobei eine Mehrzahl von R^{Y1} gleich oder verschieden sein kann,
Y eine Gruppe darstellt, die durch -C(R^{Y2})₂-, -C(R^{Y2})=C(R^{Y2})-, -C(R^{Y2})₂-C(R^{Y2})₂-, - C(R^{Y2})₂-C(R^{Y2})₂-C(R^{Y2})₂-, -N(R^{Y2})- oder -O- dargestellt ist,
R^{Y2} ein Wasserstoffatom, eine Alkylgruppe, eine Alkoxygruppe, eine Arylgruppe oder einen einwertigen Heteroringgruppe darstellt, und die vorgenannten Gruppen optional einen Substituenten aufweisen, und wenn eine Mehrzahl von R^{Y2} vorhanden ist, sie gleich oder verschieden sein können, und die Mehrzahl von R^{Y2} miteinander kombiniert werden kann, um zusammen mit den Kohlenstoffatomen, an die sie gelagert sind, einen Ring auszubilden, und wenn die Mehrzahl von R^{Y2} einen Ring ausbildet, die durch -C(R^{Y2})₂- dargestellte Gruppe eine Gruppe ist, die durch die Formel (Y-1) bis zu der Formel (Y-5) dargestellt ist, und die vorgenannten Gruppen optional einen Substituenten aufweisen:

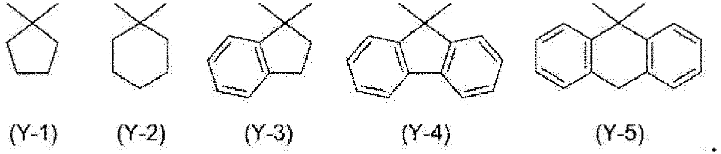

2. Polymerverbindung nach Anspruch 1, wobei die Glasübergangstemperatur 80 °C oder höher und 200 °C oder niedriger ist.

3. Polymerverbindung nach Anspruch 1 oder 2, wobei der Gehalt der durch die Formel (1-1) dargestellten konstitutionellen Einheit und der durch die Formel (1-2) dargestellten konstitutionellen Einheit 1 bis 100 Mol-% in Bezug auf die Gesamtmenge der in der Polymerverbindung enthaltenen konstitutionellen Einheiten beträgt.

4. Polymerverbindung nach einem der Ansprüche 1 bis 3, wobei die Menge der durch die Formel (1-1) dargestellten konstitutionellen Einheit 5 Mol-% oder mehr und 90 Mol-% oder weniger, bezogen auf die Gesamtmenge der in der Polymerverbindung enthaltenen konstitutionellen Einheiten, beträgt.

5. Polymerverbindung nach einem der Ansprüche 1 bis 4, wobei die Menge der durch die Formel (1-2) dargestellten konstitutionellen Einheit 5 Mol-% oder mehr beträgt und 90 Mol-% oder weniger, bezogen auf die Gesamtmenge der in der Polymerverbindung enthaltenen konstitutionellen Einheiten.

6. Polymerverbindung nach einem der Ansprüche 1 bis 5, wobei die Polymerverbindung ein gewichtsmittleres Polystyrol-Äquivalentmolekulargewicht, Mw, in einem Bereich von 1×10³ bis 1×10⁸ aufweist.

7. Verfahren zum Herstellen einer Polymerverbindung nach einem der Ansprüche 1 bis 6, wobei das Verfahren einen Schritt des Mischens einer Mischung, die enthält:
(A) eine Polymerverbindung, bestehend aus: (i) und (ii) nach Anspruch 1, und
(B) ein gutes Lösungsmittel für die Polymerverbindung;
mit einem schlechten Lösungsmittel für die Polymerverbindung bei einer Temperatur von 35 °C oder höher und 75 °C oder niedriger und des Entfernens des resultierenden Niederschlags,
wobei
das gute Lösungsmittel ein Lösungsmittel, in dem die Polymerverbindung gelöst werden kann, ohne dass die Polymerverbindung zersetzt wird, und ein Lösungsmittel ist, in dem die Löslichkeit der Polymerverbindung 1 g Polymerverbindung / 100 g gutes Lösungsmittel oder mehr bei 20 °C beträgt, und
das schlechte Lösungsmittel ein Lösungsmittel, in dem die Polymerverbindung schwer löslich ist, ohne dass die Polymerverbindung zersetzt wird, und ein Lösungsmittel ist, in dem die Löslichkeit der Polymerverbindung weniger als 1 g Polymerverbindung / 100 g schlechtes Lösungsmittel bei 20°C beträgt.

8. Herstellungsverfahren nach Anspruch 7, wobei das gute Lösungsmittel ein aromatischer Kohlenwasserstoff ist.

9. Herstellungsverfahren nach Anspruch 7 oder 8, wobei die Menge des schlechten Lösungsmittels 300 Gew.-Teile oder mehr, bezogen auf 100 Gew.-Teile des guten Lösungsmittels, beträgt.

10. Lichtemittierende Vorrichtung, umfassend eine Anode, eine Kathode und eine organische Schicht, die unter Verwendung der Polymerverbindung nach einem der Ansprüche 1 bis 6 ausgebildet wird, die zwischen der Anode und der Kathode angeordnet ist.

## Revendications

1. Composé polymère constitué par :
(i) au moins une unité constitutionnelle choisie dans le groupe constitué par une unité constitutionnelle représentée par la formule suivante (1-1) et une unité constitutionnelle représentée par la formule suivante (1-2),
dans lequel l'unité constitutionnelle représentée par la formule (1-1) peut être contenue uniquement seule ou en combinaison de deux ou plusieurs types de celle-ci, et l'unité constitutionnelle représentée par la formule (1-2) peut être contenue uniquement seule ou en combinaison de deux ou plusieurs types de celle-ci ;
et, éventuellement,
(ii) au moins une autre unité constitutionnelle qui est un groupe organique divalent obtenu en liant directement seulement un ou plusieurs groupes hydrocarbonés aromatiques divalents, seulement un ou deux groupes hétérocycliques divalents, ou au moins un groupe hydrocarboné aromatique divalent et au moins un groupe hétérocyclique divalent, et les groupes divalents obtenus en liant directement les deux ou plusieurs groupes hydrocarbonés aromatiques divalents, les deux ou plusieurs groupes hétérocycliques divalents, ou l'au moins un groupe hydrocarboné aromatique divalent et l'au moins un groupe hétérocyclique divalent peuvent être liés directement pour former un groupe organique divalent ou peuvent être liés via au moins un groupe choisi dans le groupe constitué par un groupe alkylène, un groupe représenté par -O-, un groupe représenté par -S- et un groupe représenté par -(CO)-, pour former un groupe organique divalent,
dans lequel ladite autre unité constitutionnelle peut être contenue uniquement seule ou en combinaison de deux ou plusieurs types de celle-ci ;
dans lequel la masse volumique tassée est de 0,02 g/cm³ ou plus et de 0,13 g/cm³ ou moins : 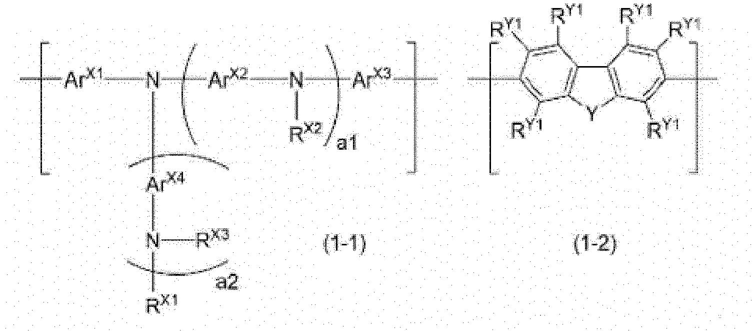 dans la formule (1-1),
a1 et a2 représentent chacun indépendamment un nombre entier de 0 ou plus et 2 ou moins,
Ar^{X1} représente une liaison directe, un groupe hydrocarboné aromatique divalent, un groupe hétérocyclique divalent ou un groupe divalent dans lequel au moins un groupe hydrocarboné aromatique divalent et au moins un groupe hétérocyclique divalent sont liés directement, et les groupes précédents ont éventuellement un substituant,
Ar^{X2}, Ar^{X3} et Ar^{X4} représentent chacun indépendamment un groupe hydrocarboné aromatique divalent, un groupe hétérocyclique divalent ou un groupe divalent dans lequel au moins un groupe hydrocarboné aromatique divalent et au moins un groupe hétérocyclique divalent sont liés directement, et le les groupes précédents ont éventuellement un substituant, et lorsqu'une pluralité de Ar^{X2} et Ar^{X4} sont présents, ils peuvent être identiques ou différents à chaque occurrence,
R^{X1}, R^{X2} et R^{X3} représentent chacun indépendamment un groupe alkyle, un groupe aryle ou un groupe hétérocyclique monovalent, et les groupes précédents ont éventuellement un substituant, et lorsqu'une pluralité de R^{X2} et R^{X3} sont présents, ils peuvent être identiques ou différents à chaque occurrence,
dans la formule (1-2),
R^{Y1} représente un atome d'hydrogène, un groupe alkyle, un groupe aryle ou un groupe hétérocyclique monovalent, et les groupes précédents ont éventuellement un substituant, une pluralité de R^{Y1} peuvent être identiques ou différents,
Y représente un groupe représenté par -C(R^{Y2})₂-, C(R^{Y2})=C(R^{Y2})-, -C(R^{Y2})₂-C(R^{Y2})₂-, -C(R^{Y2})₂-C(R^{Y2})₂-C(R^{Y2})₂-, -N(R^{Y2})- ou -O-,
R^{Y2} représente un atome d'hydrogène, un groupe alkyle, un groupe alcoxy, un groupe aryle ou un groupe hétérocyclique monovalent, et les groupes précédents ont éventuellement un substituant, et lorsqu'une pluralité de R^{Y2} sont présents, ils peuvent être identiques ou différents, et la pluralité de R^{Y2} peuvent être combinés ensemble pour former un cycle avec les atomes de carbone auxquels ils sont attachés, et lorsque la pluralité de R^{Y2} forment un cycle, le groupe représenté par -C(R^{Y2})₂- est un groupe représenté par la formule (Y-1) à la formule (Y-5), et les groupes précédents ont éventuellement un substituant :

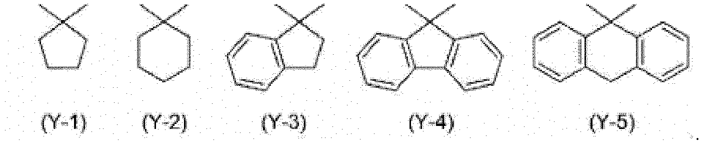

2. Composé polymère selon la revendication 1, dans lequel la température de transition vitreuse est de 80°C ou plus et de 200°C ou moins.

3. Composé polymère selon la revendication 1 ou 2, dans lequel la teneur en unité constitutionnelle représentée par la formule (1-1) et en unité constitutionnelle représentée par la formule (1-2) est de 1 à 100 % en moles par rapport à la quantité totale d'unités constitutionnelles contenues dans le composé polymère.

4. Composé polymère selon l'une quelconque des revendications 1 à 3, dans lequel la quantité de l'unité constitutionnelle représentée par la formule (1-1) est de 5 % en moles ou plus et de 90 % en moles ou moins par rapport à la quantité totale d'unités constitutionnelles contenues dans le composé polymère.

5. Composé polymère selon l'une quelconque des revendications 1 à 4, dans lequel la quantité de l'unité constitutionnelle représentée par la formule (1-2) est de 5 % en moles ou plus et de 90 % en moles ou moins par rapport à la quantité totale d'unités constitutionnelles contenues dans le composé polymère.

6. Composé polymère selon l'une quelconque des revendications 1 à 5, dans lequel le composé polymère a un poids moléculaire moyen en poids en équivalent polystyrène, Mw, dans une plage de 1 × 10³ à 1 × 10⁸.

7. Procédé de production d'un composé polymère tel que défini dans l'une quelconque des revendications 1 à 6, le procédé comprenant une étape de mélange d'un mélange contenant :
(A) un composé polymère constitué par : (i) et (ii) tels que définis dans la revendication 1 et
(B) un bon solvant pour ledit composé polymère ;
avec un mauvais solvant pour ledit composé polymère à une température de 35°C ou plus et de 75°C ou moins et l'élimination du précipité résultant,
dans lequel
le bon solvant est un solvant dans lequel ledit composé polymère peut être dissous sans décomposer le composé polymère, et un solvant dans lequel la solubilité dudit composé polymère est de 1 g de composé polymère / 100 g de bon solvant ou plus à 20°C, et
le mauvais solvant est un solvant dans lequel ledit composé polymère est difficile à dissoudre sans décomposer le composé polymère, et un solvant dans lequel la solubilité dudit composé polymère est inférieure à 1 g de composé polymère / 100 g de mauvais solvant à 20°C.

8. Procédé de production selon la revendication 7, dans lequel ledit bon solvant est un hydrocarbure aromatique.

9. Procédé de production selon la revendication 7 ou 8, dans lequel la quantité dudit mauvais solvant est de 300 parties en poids ou plus par rapport à 100 parties en poids dudit bon solvant.

10. Dispositif électroluminescent comprenant une anode, une cathode et une couche organique formée en utilisant le composé polymère selon l'une quelconque des revendications 1 à 6 disposé entre ladite anode et ladite cathode.
